(19) Europäisches Patentamt

European Patent Office

Office européen des brevets

(11) **EP 0 627 137 B1**

(12) **EUROPEAN PATENT SPECIFICATION**

(45) Date of publication and mention
of the grant of the patent:
**15.03.2000 Bulletin 2000/11**

(21) Application number: **94905570.1**

(22) Date of filing: **22.12.1993**

(51) Int. Cl.[7]: **H03L 7/081**, H03K 5/13

(86) International application number:
**PCT/US93/12693**

(87) International publication number:
**WO 94/15401 (07.07.1994 Gazette 1994/15)**

(54) **DIGITALLY CONTROLLED PHASE SHIFTER**

DIGITAL GESTEUERTE PHASENSCHIEBER

DEPHASEUR COMMANDE NUMERIQUEMENT

(84) Designated Contracting States:
**AT BE CH DE DK ES FR GB IT LI NL PT SE**

(30) Priority: **23.12.1992 US 994831**

(43) Date of publication of application:
**07.12.1994 Bulletin 1994/49**

(73) Proprietor:
**COMSTREAM CORPORATION
San Diego, CA 92121 (US)**

(72) Inventors:
• **GOLDENBERG, Yoav
26300 Kiryat Haim (IL)**
• **GUR, Shimon
San Diego, CA 92122 (US)**

(74) Representative:
**Orchard, Oliver John et al
JOHN ORCHARD & CO.
Staple Inn Buildings North
High Holborn
London WC1V 7PZ (GB)**

(56) References cited:
**EP-A- 0 158 980          FR-A- 2 167 259
FR-A- 2 589 651          GB-A- 2 233 177
US-A- 5 173 617**

## Description

Field of Invention

The present invention relates generally to signal controlled phase shifters and more particularly to a phase shifter including at least several delay elements having connections to an output terminal controlled in response to the value of a control signal.

The invention is also related to a signal multiplexer responsive to at least several signals and more particularly to such a multiplexer which is responsive to a reflected coded signal.

Background Art

Signal controlled phase shifters are usually analog devices including a variable reactance, such as a varactor, having a value controlled by the amplitude of a voltage. Such phase shifters are frequently employed in voltage controlled variable frequency oscillators, such as are employed in phase locked loops. In such applications, a fixed clock is supplied to the voltage controlled, variable frequency oscillator to derive an output frequency that is fed back to one input of a phase detector, having a second input responsive to an input frequency. The phase detector derives an error voltage that is fed to a loop filter which supplies the voltage controlled oscillator with a variable amplitude voltage for controlling the oscillator output frequency. Phase locked loops are used to lock a receiver to an incoming frequency with zero frequency or phase error. In receivers responsive to variable phase signals representing digital data, e.g. QPSK or BPSK signals, a demodulator of the receiver is locked to a symbol frequency with zero phase error. Such locking is usually performed with a first or second order phase locked loop.

The prior art analog phase shifters and analog based phase locked loops have the usual disadvantages associated with analog circuitry, i.e., lack of repetitiveness in manufacturing and performance unless "tweaking" procedures are used, low yield production, inaccuracy and the need to adapt the analog circuitry to the remaining parts of the equipment. To overcome these problems, digitally based phase locked loops have been developed. One digitally based phase locked loop responsive to base band signals to be demodulated includes an analog-to-digital converter having one input responsive to such a signal. The converter has a second input responsive to a sampling clock having a variable frequency controlled by the digital phase locked loop. The converter derives a multi-bit digital output signal having a variable value dependent on the amplitude of the base band signal when a sample derived by the clock occurs. The base band signal is subject to a full gamut of amplitude variations because of imperfections in the transmission and processing of the signal between the origination site and the phase locked loop site. Normally at least two samples of the variable phase signal are taken during each symbol.

The variable digital output signal of the converter is supplied to a symbol data decoder and error generator. The symbol data decoder and error generator derives a data output signal representing the digital value of the symbol, as well as a signal indicative of the phase error between the variable phase signal and the sampling clock. The phase error digital control signal is supplied to a symbol timing loop filter, which in turn drives a direct digital synthesizer, having a digital output signal with values representing the amplitude of a sine wave. The direct digital synthesizer drives a digital to analog converter, having a sinusoidal-like output with values equal to the digital values derived by the synthesizer. The digital to analog converter sinusoidal-like output is supplied to a lowpass filter. Direct digital synthesizers are frequency limited to a few megaHertz, so the lowpass filter output is considerably lower in frequency than the base band signal supplied to the analog-to-digital converter. To provide the analog-to-digital converter with an acceptable sampling frequency, the lowpass filter output is supplied to a frequency multiplying phase locked loop. Hence, this prior art system is relatively complex, requiring an analog phase locked loop within the digital phase locked loop, as well as a digital to analog converter and a lowpass filter.

Another prior art digitally based system for demodulating variable phase intelligence signals supplied to a receiver includes an analog-to-digital converter having first and second inputs respectively responsive to the base band signal and a fixed frequency sampling clock. The analog-to-digital converter derives a digital output having values indicative of the amplitude of the base band signal supplied to the converter at the time each sampling clock occurs. To determine the precise level of the analog-to-digital converter output signal, an interpolator responds to the converter output to find the sampled values at the desired time. The interpolator is either of the finite or infinite impulse response type. The interpolator derives a digital output which is supplied to a symbol timing processor having an output which updates coefficients used in the interpolator. The symbol timing processor also derives data representing output signals.

One further proposed digitally based phase locked loop samples the amplitude of a received signal. The resulting samples are processed to derive an error control signal for the frequency of the sampling source. The error control signal controls the frequency of the sampling source by selecting one of several predetermined frequency division factors for a fixed clock source. As the error changes, the frequency division factor changes to vary the sampling source frequency by discrete, fixed amounts. This type of phase lock loop has the disadvantage of not being suitable for high frequency sampling sources and does not provide high frequency resolution.

It is also known from Kubinec, U.S. Patent No. 4,894,626, to provide a variable time delay circuit in the form of a variable length shift register having multiple cascaded delay units selectively connected between an input terminal and an output terminal. Switches control which of the delay units, each having about the same delay time, are interposed between the input and output terminals.

French Patent No. 2589651 discloses a semiconductor delay line particularly for logic circuits including plural cascaded delay elements connected between an input terminal and an output terminal. The number of delay elements effectively connected between the terminals is controlled by output bits of a decoder so there is a correlation between the decoder output and the controlled delay time between the input and output terminals.

Lofgren et al, U.S. Patent No. 4,922,141, discloses a phase-locked loop including a crystal oscillator, a phase detector and a variable delay circuit including several cascaded delay elements, each having the same controlled variable delay time. The delay circuit and one input of the phase detector are driven by the oscillator. Another input of the phase detector is driven by the output of the delay circuit. The phase detector responds to its inputs to derive an error signal for controlling the delay times of the several cascaded delay elements so the delay introduced by the delay circuit equals one period of the oscillator output.

In the specification of United States patent number 5,173,617, which was published on December 22 1992, there was proposed a digital phase locked loop that does not depend on a voltage controlled oscillator (VCO) for phase locking. A phase detector (PD), terminated with a latch, controls an up/down counter that programs an increase/decrease of delay on the delay line. The tapped output of the delay line goes through a two phase generator which in turn feeds back to the PD for comparison with the reference clock. This process is repeated until phase locking is obtained.

Features of embodiments to be described below by way of example in illustration of the present invention are that there are provided a new and improved signal controlled phase shifting apparatus and method, a new and improved signal controlled variable frequency oscillator and a method of deriving a variable frequency wave in response to a control signal, a new and improved digitally based phase locked loop and a method of digitally phase locking an input frequency and a clock, a digitally based phase locked loop including a digitally controlled asynchronous phase shifter responsive to a fixed frequency clock, and a digitally based phase locked loop suitable for high frequencies that is relatively inexpensive because it employs a fixed frequency oscillator reference.

In particular embodiments to be described below, by way of example in illustration of the invention, the phase of a periodic waveform is shifted to a selected one of at least several different discrete values by imposing a delay on the periodic waveform for a time determined by the selected discrete value to derive the phase shifted periodic waveform so that, as the selected value changes, the imposed delay changes. The selected value is reset to an initial value in response to the periodic waveform being shifted by the imposed delay through an integral multiple of about one cycle of the periodic waveform.

An apparatus to be described below, by way of example in illustration of the invention may respond to a control signal representing a phase change to be applied to the periodic waveform. The apparatus includes a circuit responsive to the periodic waveform for deriving at least several replicas of the periodic waveform. The replicas have different time delays with respect to each other. A means responsive to the phase change representing signal couples a selected one of the replicas to a first output terminal as a function of the value of the control signal. The apparatus includes means for resetting the control signal to the predetermined value when the replica at the output terminal has shifted through an integral multiple of about one cycle of the periodic waveform.

The following description and drawings disclose, by means of examples, the invention which is characterised in the appended claims, whose terms determine the extent of the protection conferred hereby.

In the drawings:-

Fig. 1 is a partial block and partial circuit diagram of a phase locked loop incorporating a digitally controlled asynchronous phase shifter in accordance with one embodiment of the invention;

Fig. 2 is a block diagram of a preferred embodiment of the multiplexer included in Fig. 1;

Fig. 3 is a block diagram of another embodiment of an asynchronous digitally controlled phase shifter in accordance with the present invention;

Fig. 4 is a schematic diagram of a delay unit included in the structure illustrated in Fig. 3;

Fig. 5 is a circuit diagram of a controller included in Fig. 3; and

Fig. 6 is a flow diagram of a sequencer included in Fig. 5.

Description of the Preferred Embodiment

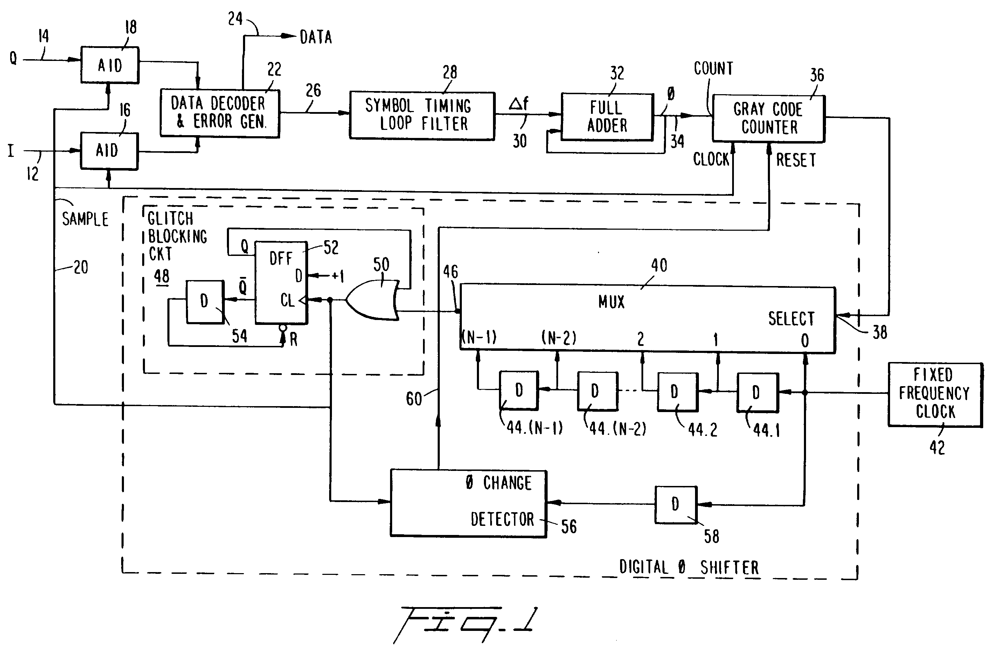

Reference is now made to Fig. 1 of the drawing, a phase locked loop responsive to a receiver base band quadrature phase shift key signal having I and Q components on leads 12 and 14, respectively. The signals on leads 12 and 14 are typically degraded due to the transmitting and receiving processes occurring prior to derivation of the signals on these leads so that the original variable phase I and Q channel (bi-level) amplitudes are transformed into signals having a gamut of amplitudes between a pair of levels on leads 12 and 14.

A typical bit, symbol or baud rate for the signal on leads 12 and 14 is 20 megaHertz. The signals on leads 12 and 14 are respectively supplied to analog-to-digital converters 16 and 18, each of which derives a multi-bit parallel digital signal having a value commensurate with the amplitudes of the signal supplied to the converters at the time the converters are supplied with a variable frequency sampling clock via lead 20. In the usual receiver including a phase locked loop the sampling clock frequency is twice the frequency of the symbol rate of the signals on leads 12 and 14, to provide early and late gate samples, as is common in the prior art.

The output signals of converters 16 and 18 are supplied to digital data decoder and error generator 22 for deriving parallel multi-bit data and error outputs on buses 24 and 26, respectively. The error signal on bus 26 represents (digitally) the deviation of the sampling phase provided by the signal on lead 20 relative to the ideal sampling point.

The error representing signal on bus 26 is supplied to symbol timing loop filter 28 for deriving on bus 30 a parallel multi-bit digital control signal representing the frequency error associated with the error signal on bus 26. Symbol timing loop filter 28 generally derives one frequency error signal for each symbol on leads 12 and 14. The structure of converters 16 and 18, data decoder and error generator 22 and symbol timing loop filter 28 is conventional and needs no further description or explanation.

The frequency error signal derived by symbol timing loop filter 28 on bus 30 controls the frequency and phase of the sample clock on lead 20. To this end, the frequency error signal on bus 30 is converted by full adder 32, which is effectively a digital integrator, into a digital phase error signal. The overflow bit of the phase error signal is supplied to lead 34 to advance the count in reflected (preferably Gray) code counter 36, having a reflected code multi-bit parallel output that is supplied to select input 38 of multiplexer 40. Multiplexer 40 includes N signal input terminals, designated 0,1,2...(N-2) and (N-1). The N signal input terminals of multiplexer 40 are responsive to fixed frequency clock source 42 and delayed replicas thereof. Signal input terminal 0 of multiplexer 40 is directly responsive to the fixed frequency output of clock 42, while signal input terminals 1,2...(N-2),(N-1) are responsive to replicas that are respectively delayed by $\Delta T,2\Delta T...(N-2)\Delta T,(N-1)\Delta T$, where $\Delta T$ is a delay time.

The delayed replicas supplied to input terminals 1,2...(N-2),(N-1) are respectively derived from cascaded delay elements 44.1,44.2...44.(N-2),44.(N-1). In a preferred embodiment, each of delay elements 44 includes a pair of cascaded unity gain inverting amplifiers; the propagation delay of the cascaded amplifiers is equal to the delay time associated with each of the delay elements. The total delay time of cascaded delay elements 44.1,44.2...44.(N-2),44.(N-1) for all possible delay times of the delay elements exceeds one cycle of fixed frequency clock 42 and for the best case the delay time is slightly in excess of one cycle of the fixed frequency clock 42. In a preferred embodiment, there are 128 ($2^7$) signal input terminals of multiplexer 40, such that N = 128 and there are 127 delay elements 44.

Multiplexer 40 responds to the digital control signal at select input 38 to supply one of the delayed replicas at signal input terminals 0,1,2...(N-2),(N-1) to the multiplexer output terminal 46. The signal at terminal 46 is thereby a time delayed replica of fixed frequency clock source 42. The delay is commensurate with a phase shift, at the frequency of clock source 42, determined by the value of the digital control signal at terminal 38.

Because of a feedback arrangement (described _infra_) within the phase locked loop, the output of multiplexer 40 at terminal 46 returns to an in-phase relationship with the phase of clock 42 when the phase of the clock has been shifted through approximately one complete cycle, i.e., 360°, thereof. Because of this feedback arrangement, the phase shifter comprising multiplexer 40 and delay elements 44 is asynchronous and it is not necessary for the delay time associated with each of elements 44 to remain absolutely fixed. Hence, the propagation delay time of elements 44 can vary as a function of supply voltage, temperature and manufacturing processes. In general, the frequency of clock 42 is slightly in excess of twice the frequency of the symbol rates of the signals on leads 12 and 14. This causes the phase of the wave at terminal 46 to monotonically advance slightly over many cycles of clock 42. There is a corresponding change in the sampling frequency coupled from terminal 46 to lead 20 via glitch blocking circuit 48. The frequency error signal on bus 30 is translated by full adder 32 into a phase error signal having an overflow bit applied to lead 34. After many cycles of clock 42, there is an incremental change in the phase error signal derived by full adder 32 resulting in a monotonically changing phase input signal being supplied to terminal 38 of multiplexer 40.

The sampling clock coupled from terminal 46 to lead 20 causes a finite change in the output of filter 28 on bus 30. This results in changes in the output of full adder 34 and the input signal at select input 38 of multiplexer 40. Even if there is no change in the frequency error signal derived from loop filter 28, the output of full adder or integrator 32 changes, provided the frequency error signal derived from the loop filter has a finite, non-zero value. Thereby, the phase of the clock replica at terminal 46 monotonically changes slowly over many cycles of clock 42. Each phase change is by a discrete amount, related to the value of the signals supplied to input 38 and the delay times associated with delay elements 44. The phase at output 46 remains constant relative to the phase of clock 42 for many cycles of the clock until there is a change in the value of the signal derived by Gray code counter 36 and supplied to input 38 of multiplexer 40.

In response to the phase of the clock replica at terminal 46 being displaced by about 360°, i.e., approximately one cycle, of clock 42, Gray code counter 36 is reset to 0. In response to counter 36 being reset to 0, input 38 of multiplexer 40 is set to 0, resulting in the clock at signal input terminal of multiplexer 40 being coupled to output terminal 46. The output of multiplexer 40 is thereby in phase with the output of clock 42, to enable a new phase shift cycle to be instigated.

Whenever multiplexer 40 is switched, a glitch can be created at output terminal 46. It is very important to prevent this glitch from arriving at terminal 20. Glitch blocking circuit 48 for preventing such a glitch includes OR gate 50, D-flip-flop 52 and delay element 54. One input of OR gate 50 is connected directly to output 46 of multiplexer 40 while the OR gate output is connected to a clock input of D-flip-flop 52, while the flip-flop data (D) input is supplied with a constant binary 1 level. Clock pulses on lead 20 are supplied to a clock input of Gray code counter 36 so that the Gray code counter responds to the leading edges of the clock pulses. Flip-flop 52 includes Q and Q output terminals respectively connected to a second input of OR gate 50 and to asynchronous reset (R) input of flip-flop 52 by way of delay element 54. Delay element 54 has a delay time greater than the time required for multiplexer 40 to produce a phase change at output terminal 46 in response to a change in the value of the signal at input 38; the later time is referred to herein as the multiplexer propagation delay time.

In response to a leading edge being derived at output terminal 46 of multiplexer 40, a leading edge is derived by OR gate 50. The leading edge derived by OR gate 50 activates flip-flop 52 so the Q output thereof changes from a 0 to a 1 state, thus forcing the output of OR gate 50 to a binary 1 state. The output of OR gate 50 remains in the 1 state for a period greater than the multiplexer propagation delay. After the delay time determined by delay element 54 has elapsed, a binary 1 to 0 transition at the output of element 54 resets flip-flop 52. With flip-flop 52 activated to a reset state, the output of OR gate 50 follows transitions at output terminal 46 of multiplexer 40. A delay apparatus internal to element 54 stops resetting of flip-flop 52 by producing a binary 0 to 1 transition at the output of element 54.

The output of OR gate 50 is supplied to lead 20, to cause the signals on leads 12 and 14 to be sampled by analog-to-digital converters 16 and 18 twice during each symbol period. In addition, the output of OR gate 50 is supplied to one input of phase change detector 56, having a second input responsive to the output of clock 42, as coupled through delay element 58. Delay element 58 has a delay time equal to the multiplexer propagation delay time plus the propagation delay time of OR gate 50. When there is a change in the phase lead-phase lag relationship of the leading edges of the two inputs of detector 56, the detector derives a pulse on output lead 60 thereof; this pulse is supplied to the reset input of Gray code counter 36. Detector 56 and the circuitry associated therewith are basically detectors for a phase shift of approximately n x 360° (where n is an integer including 1) of the wave at terminal 46 relative to the output wave of clock source 42.

To prevent lockup of Gray code counter 36 to a 0 state, detector 56 is prevented from deriving a second output pulse immediately after it derives a first output pulse and for an additional time thereafter until the signal at output terminal 46 has been phase shifted adequately. This result is achieved by inhibiting the output of detector 56 when the output of counter 36 has a value of 0 and values associated with a few degrees above 0°. To this end, the output of detector 56 is coupled through a gate (not shown) and the output of counter 36 is supplied to a detector (not shown) which supplies the gate with an inhibit signal when the counter output is in the range associated with phase shift values for clock 42 of 0° to as much as 340°, for a worst case situation. Because the bit rates of the signals on leads 12 and 14 can be considered constant and at a reference value which is a few kiloHertz (e.g. 7 kHz) lower than the frequency of clock 42, the phase change at output 46 of multiplexer 40 always increases in the same direction relative to clock 42 so detector 56 cannot supply a pulse to lead 60 as a result of a zero phase difference between the output of clock 42 and the signal at terminal 46.

In a preferred embodiment, multiplexer 40 is responsive to a reflected Gray coded signal having M bits, where $N = 2^M$, and N is the total number of the 0,1,2...(N-1) inputs of the multiplexer from delay elements 44. Reflected coded signals are desirable because only one binary value thereof changes for each change of one numeral of a base 10 value. In response to a change of one binary value in the signal at input 38, multiplexer 40 selects a progressively larger or smaller signal at one of its 0, 1, 2...(N-2), (N-1) inputs.

In general, multiplexer 40 includes an array of (N-1) gates, each having two signal inputs (A and B) and a control input (S) responsive to a binary level for determining which of the two inputs is coupled to an output. The gates of the array are arranged in a tree, such that row 0 of the tree has N/2 gates, row 1 of the tree has N/4 gates, row 2 of the tree has N/8 gates and row r has $N(2^{-(r+1)})$ gates.

The signal inputs of the gates of row 0 are connected to signal input terminals of the multiplexer so that the even numbered gates in row 0 have inputs which are crossed with respect to the multiplexer signal input terminals, while direct connections are provided between the remaining gates of row 0 and the multiplexer signal input terminals. The outputs of the gates of row 0 are coupled to the A and B inputs of the gates of adjacent, row 1 in a similar manner. The outputs of the gates of the succeeding rows are connected to the A and B inputs of the next adjacent row in a similar manner.

In general for a multiplexer for routing N input signals to an output terminal, the A and B inputs of gate k (where k is an even integer from 0 to $\frac{N}{2}$ - 2)) in row 0 are respectively connected to be responsive to the signals at signal input terminals 2k and (2k+1) of the multiplexer while the A and B inputs of gate (k+1) in row 0 are respectively connected to be responsive to the signals at signal input terminals (2k+3) and 2(k+1). The A and B inputs of gate j (where j is an even integer from 0 to $N2^{-(r+1)}$-2) in row (r+1) are respectively connected to be responsive to the signals at the output terminals of gates 2j and (2j+1) of row r while the A and B inputs of gate (j+1) in row (r+1) are respectively connected to be responsive to the signals at the output terminals of gates (2j+3) and (2j+1) of row r, where r is selectively each of 0 to (M-1) and j is selectively each of 0, 1, 2...N($2^{-r-1}$). The particular multiplexer array enables layout and routing of outputs from delay elements 44 to multiplexer 40 directly and between the gates within the multiplexer, with no additional crossing lines, so it is possible to achieve the same delay for all paths through the multiplexer with good accuracy.

The control inputs of the gates of row 0 are responsive to the lowest order bit derived from Gray code counter 36, the control inputs of the gates of row 1 are responsive to the next to lowest order bit derived by counter 36, etc. so the control input of the single gate of the last row (M-1) is responsive to the highest order bit derived by counter 36. Thereby in response to the reflected coded signal changing by one in base 10, there are changes to the status of all the gates in only one row of the tree.

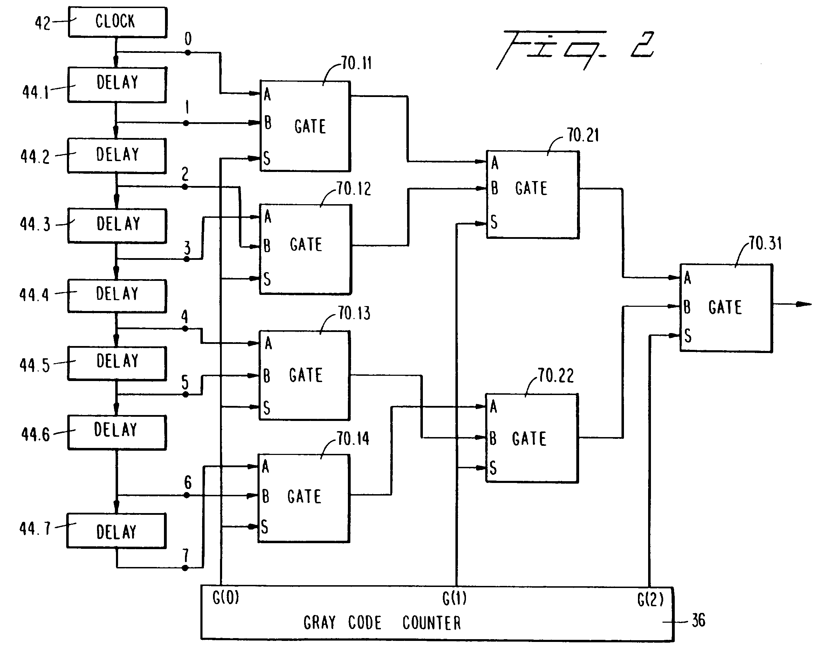

A simplified version of multiplexer 40 responsive to the output of fixed frequency clock 42 and seven delayed replicas thereof and the output of Gray counter 36 is illustrated in Fig. 2. In Fig. 2, fixed frequency clock 42 drives cascaded delay elements 44.1, 44.2...44.7. The output of clock 42 is applied to signal input terminal 0 of multiplexer 40, while the outputs of delay elements 44.1, 44.2...44.7 are respectively applied to signal input terminals 1, 2...7 of the multiplexer. For the simplified situation of Fig. 2, multiplexer 40 includes an array of seven gates, arranged in three rows, such that row 0 (the first row) includes four gates, row 1 (the second row) includes two gates and row 2 (the third, i.e., last, row) includes one gate. Hence, row 0 includes gates 70.11, 70.12, 70.13 and 70.14, row 1 includes gates 70.21 and 70.22 and row 2 includes gate 70.31.

Each of gates 70 has two signal input terminals A and B, a control signal input S and an output terminal. In response to the signal at terminal S having a binary 0 value, the signal at terminal A is coupled to the gate output terminal; in response to the signal at terminal S having a binary 1 value, the signal at terminal B is coupled to the gate output terminal. The A and B inputs of gate 70.11 are respectively responsive to the signals at multiplexer signal input terminals 0 and 1 while the A and B inputs of gate 70.12 are respectively responsive to the signals at multiplexer signal input terminals 3 and 2. A similar relationship exists for the A and B input terminals of the remaining gates of row 0 so that the A and B inputs of gate 70.13 are responsive to the signals at signal input terminals 4 and 5 of the multiplexer while the A and B inputs of gate 70.14 are respectively responsive to the signals at multiplexer input terminals 7 and 6. The S control inputs of gate 70.11-70.14 are driven in parallel by the least significant bit output of Gray code counter 36.

The S control inputs of gates 70.21 and 70.22 of row 1 are driven in parallel by the second least significant bit output of Gray code counter 36. The A and B inputs of gate 70.21 are respectively responsive to the outputs of gates 70.11 and 70.12, while the A and B inputs of gates 70.22 are respectively responsive to the outputs of gate 70.14 and 70.13.

The S control input of gate 70.31 of row 2 is responsive to the most significant bit output of the Gray code signal. The A and B inputs of gate 70.31 are respectively responsive to the outputs of multiplexer 70.21 and 70.22. For the simplified situation of Fig. 2, the multiplexer output is derived from gate 70.31.

In operation, for each one bit change in the Gray code signal supplied to gates 70, there is a one-step change of the number of the multiplexer input signal terminal coupled to the multiplexer output. Thus, for example, in response to the Gray code supplied to gate 70 having a 000 value, the output of gate 70.31 is the signal at signal input terminal 0 of the multiplexer. In this situation, all of gates 70 are activated so that the signal at the A inputs thereof are coupled to the gate output, resulting in the signal at multiplexer input terminal 0 being coupled through gates 70.11, 70.21 and 70.31 to the multiplexer output. In response to the Gray code signal advancing from 000 to 001, the signal at multiplexer input terminal 1 is coupled to the output of gate 70.31 via gates 70.11 and 70.21. In response to the Gray code signal advancing to 011, the signal at multiplexer input terminal 2 is coupled through gates 70.12, 70.21 and 70.31 to the multiplexer output. In response to the Gray code signal advancing to 010, the signal at multiplexer input terminal 3 is coupled via gates 70.12, 70.21 and 70.31 to the multiplexer output. In response to the Gray coded signal being incremented by a count of 1 from 010 to 110, the signal at multiplexer input terminal 4 is coupled through gates 70.13, 70.22 and 70.31 to the multiplexer output. In response to the Gray coded signal having a value of 111, the signal at multiplexer input terminal 5 is coupled via gates 70.13, 70.22 and 70.31 to the multiplexer output. In response to the Gray coded signal having a value of 101, the signal at multiplexer input terminal 6 is coupled via gates 70.14, 70.22 and 70.31 to the multiplexer output. Finally, in response to the Gray coded signal having a value of 100, the signal at multiplexer input terminal 7 is coupled via gates 70.14, 70.22 and 70.31 to the multiplexer output terminal. Hence, the multiplexer output advances sequentially between the signals at the multiplexer input terminals in response to each one-bit change of the Gray coded control signals supplied to gates 70. Since only one bit of the Gray coded signal can change at a time, the gates of only one row of the array change at a time.

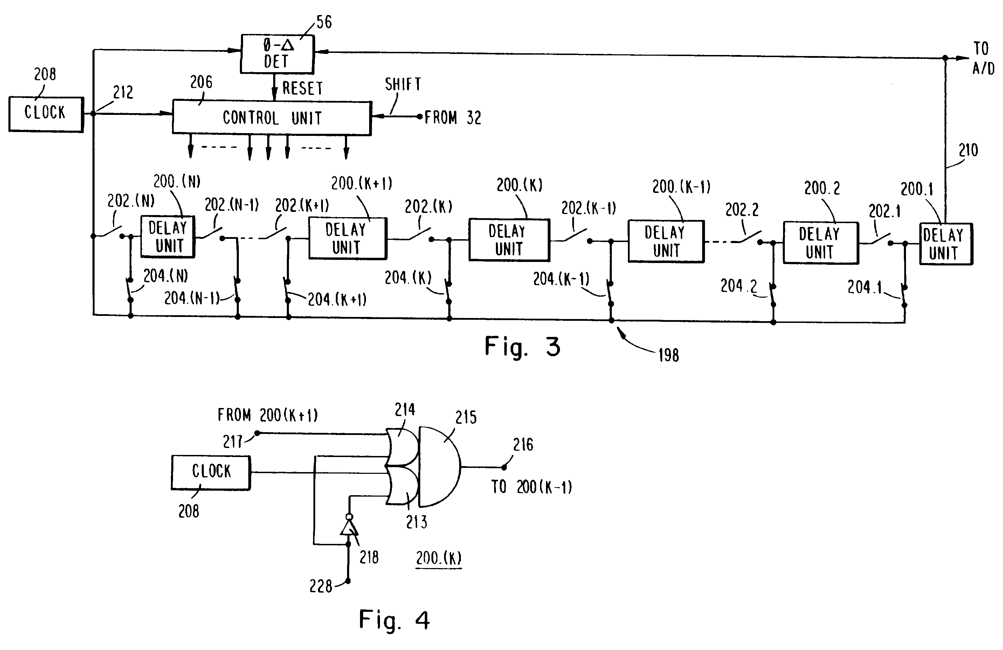

The digital phase shifter of Fig. 1 requires glitching blocking circuit 48. It is desirable under many circumstances to completely obviate the possibility for glitches to occur and, therefore, to remove glitching blocking circuit 48. To these ends, digitally controlled asynchronous phase shifter 198, Fig. 3, is provided. Phase shifter 198 replaces the entire digital phase shifter of Fig. 1 in a phase lock loop receiver. The receiver of Fig. 1 is modified by deleting Gray code counter 36 so phase shifter 198 is driven by the output of full adder 32 so the shift command input of the control unit of phase shifter 198 changes as the full adder output changes.

Phase shifter 198 can be considered as a variable frequency and phase oscillator responsive to the $\Delta f$ signal derived from loop filter 28 in a similar manner to the way the digital phase shifter of Fig. 1 functions in response to the frequency control output signal $\Delta f$ derived from loop filter 28.

The variable phase clock source illustrated in Fig. 3 includes N delay units 200.1, 200.2...200.(k-1), 200.(k), 200.(k+1)...200.(N). A selected number (i) of delay units 200 are cascaded with each other and fixed frequency and phase clock source 208 by switches 202 and 204. The states of switches 202 and 204 are controlled by control unit 206 to be responsive to fixed frequency and phase clock source 208. There is a total of N switches 202 and N switches 204, such that one of switches 202 and 204 is associated with a different one of delay units 200. Hence, switches 202.1 and 204.1 are associated with delay unit 200.1, switches 202.2 and 204.2 are associated with delay unit 200.2, switches 202.(k) and 204.(k) are associated with delay unit 200.(k) etc. The output of delay unit 200.1 is considered as having a "zero" delay time associated with it. Switches 202 connect the various delay units 200 in series with each other while switches 204 selectively couple inputs of the delay units to the output terminal of clock source 208. Switches 202 and 204 are activated by control unit 206 so the switches associated with a particular delay unit are activated in a make before break mode.

Initially, all of switches 204 are in a closed state and all of switches 202 are in an open state. Control unit 206 responds to a shift command signal supplied to it by the output of full adder 32 (Fig. 1) and to the leading edge of the output of clock 208 to activate switches 202 and 204 so that in response to leading edge of the first clock pulse following the first shift signal, switches 202.1 and 204.1 change state to close switch 202.1 and open switch 204.1. Because all of switches 204 (and particularly switch 204.2) are closed, the make before break operation occurs. In response to the leading edge of the first clock pulse following the second shift pulse supplied to control unit 206, switches 202.2 and 204.2 respectively close and open. Operation continues in this manner so switches 202.(k) and 204.(k) respectively close and open in response to the leading edge of the first clock pulse after shift pulse k is applied to control unit 206. Control unit 206 is reset to 0, to reinitiate the initial condition state previously mentioned, in response to a reset output being derived by phase change detector 56. Switches 202, once closed, remain closed while switches 204, once opened, remain open until control unit 206 is reset by the output of detector 56, which occurs when the wave train at output terminal 210 has been shifted by slightly more than one cycle of the frequency of clock 208, as derived at the clock output terminal 212.

In the initial condition state of the apparatus illustrated in Fig. 3, one delay unit 200.1 is effectively in the circuit so there is a slight, fixed change in phase of the waveform derived by source 208 between output terminal 212 of the source and output terminal 210. In response to shift pulse 1 being supplied to control unit 206, the delay of delay unit 200.2 is interposed and the phase of clock source 208, as coupled to terminal 210, is modified accordingly.

In response to shift pulse k being supplied to control unit 206, the delays of delay units 200.1, 200.2..., 200.(k) and 200.(k+1) are interposed between the output of fixed clock 208 and terminal 210, so that there is a phase shift of about $(k+1)\Delta T$, where $\Delta T$ is the approximately equal delay time of each of delay units 200. The delay times of units 200 are approximately equal to each other but are not exactly equal to each other because of manufacturing tolerances of the delay units and variations which occur in the delay units with and during use. The total delay time of delay units 200.1-200.(N) is slightly more than the period of one cycle of fixed clock source 208. Under most circumstances, control unit 206 is reset by the output of detector 56 prior to switch 202.(N) being activated from its normally open to its normally closed state and switch 204.(N) being activated from its normally closed to its normally open state.

Reference is now made to Fig. 4 of the drawing, a schematic diagram of a single delay unit 200.(k) of cascaded delay units 200.1-200.(N). Delay unit 200.(k) includes OR gates 213 and 214, having outputs supplied to inputs of AND gate 215. (Actually gates 213-215 are formed as a single integrated circuit OR-AND gate on a semiconductor chip; all of the delay units illustrated in Figs. 1 and 3 are integrated circuits on a semiconductor chip.) AND gate 215 includes output terminal 216 connected directly to an input of the OR gate of delay unit 200.(k-1) corresponding with a similar input of OR gate 214 of delay unit 200.(k). Similarly, one input of OR gate 214 of delay unit 200.(k) is connected to the output terminal of delay unit 200.(k+1) corresponding with output terminal 216 of delay unit 200.(k+1). OR gates 213 and 214 are driven by complementary versions of the signal at terminal 228, which is derived from an output of control unit 206 associated with delay unit 200.(k). These complementary inputs actually implement the symbolic switches 202(k) and 204(k) of Fig. 3, such that the inputs OR gates 213 and 214 respectively implement switches 204(k) and 202(k). The signal at terminal 228 is supplied directly to an input of OR gate 214 and to an input of OR gate 213 via inverter 218. A second input of OR gate 213 is responsive to the output of clock 208.

The propagation delay of OR gates 213 and 214, in combination with the propagation delay of AND gate 215, provides the delay of unit 200.(k) between output terminal 217 of delay unit 200.(k+1) and the input to delay unit 200.(k-1), at terminal 216. A similar propagation delay is provided by delay unit 200.(k) for clock 208 between the input of OR gate 213 and terminal 216. The structure of gates 213-215, as an OR-AND gate, provides symmetrical delay times for the leading and trailing edges of pulses supplied to delay unit 200.(k).

In response to the signal from control unit 206 at terminal 228 having a binary 0 value, OR gate 213 derives a binary 1 output to enable AND gate 215 to be responsive to transitions at the output of OR gate 214. The outputs of gates 213 and 214 are thereby insensitive to pulses from clock source 208. Under these conditions, OR gate 214 responds to binary 1 to 0 transitions at the output of the AND gate of delay unit 200.(k+1) corresponding with output 216 of AND gate 215. Thereby, while the signal level at terminal 228 of delay unit 200.(k) is at a 0 level, binary 0 to 1 transitions in the output of delay unit 200.(k+1) are propagated to output 216 of AND gate 215 and to the input of delay unit 200.(k-1) with a delay time equal to the delay time of delay unit 200.(k).

In contrast, in response to the level at terminal 228 being a binary 1, the output of AND gate 215 is a replica of the signal from clock source 208. This is because gate 214 is set at a binary 1 level while the output of control unit 206 is a binary 1 level to enable AND gate 215 to be responsive to transitions at the output of OR gate 213 and to prevent coupling of transitions in the signal at terminal 217 through OR gate 214 to AND gate 215. Under these conditions, the output of OR gate 213 is a replica of the output of clock 208. Thereby, output 216 of AND gate 215 is driven to the binary 1 state in response to binary 1 levels being derived from clock source 208. The binary 1 pulses at terminal 216 occur at a time that is delayed from the occurrence time of the clock pulses at the input of gate 213 by the propagation time of delay unit 200.(k).

The most straightforward approach for implementing control unit 206 is to provide a separate control stage for each of delay stages 200.1-200.(N). Since there is a large number of delay units, with N being a number such as 64, 128 or 256, such an approach uses excessive amounts of hardware. To reduce the amount of hardware to manageable levels, delay units 200.1-200.(N) are divided into a number of groups, each including the same number of delay units. In the specifically described embodiment, 16 delay units are included in each group and a total of four groups is included so N = 64.

The delay units 200 in a particular group are activated in sequence, starting with the lowest number delay unit of a particular group and proceeding to the highest number unit of the group. Thus, for example, in the first group, switches 202.1-202.16 are sequentially closed, interspersed with sequential opening of switches 204.1-204.16. While switches 202.1-202.16 and 204.1-204.16 are being sequentially activated, the remaining switches associated with delay units 200.17-200.(N) are also opened and closed in sequence. Operation of the switches of delay units 200.17-200.(N) while the switches of delay units 200.1-200.16 are being operated has no effect on the delay interposed between terminals 212 and 210 because switch 202.16 is open during the transitions in the states of switches 202.1-15 and 204.1-15. When switches 202.16 and 204.16 are closed and opened, respectively, it is guaranteed that switches 202.17 and 204.17 are respectively open and closed. After switches 202.1-202.16 and 204.1-204.16 have been sequentially activated, the same structure of control unit 206 that controlled the switches of delay units 200.1-200.16 is used to sequentially close switches 202.17-202.32, interspersed with opening of switches 204.17-204.32. Switches 202.1-16 remain in a static closed state while switches 204.1-16 remain in a static open state. Switches 202.1-16 and 204.1-16 remain in a static state and then the switches of delay units 200.1-200.32 remain in a static state and the switches of delay units 200.33-200.48 are sequentially activated. Operation continues in this manner until phase change detector 56 derives a reset pulse, at which time control unit 206 is activated back to an initial condition.

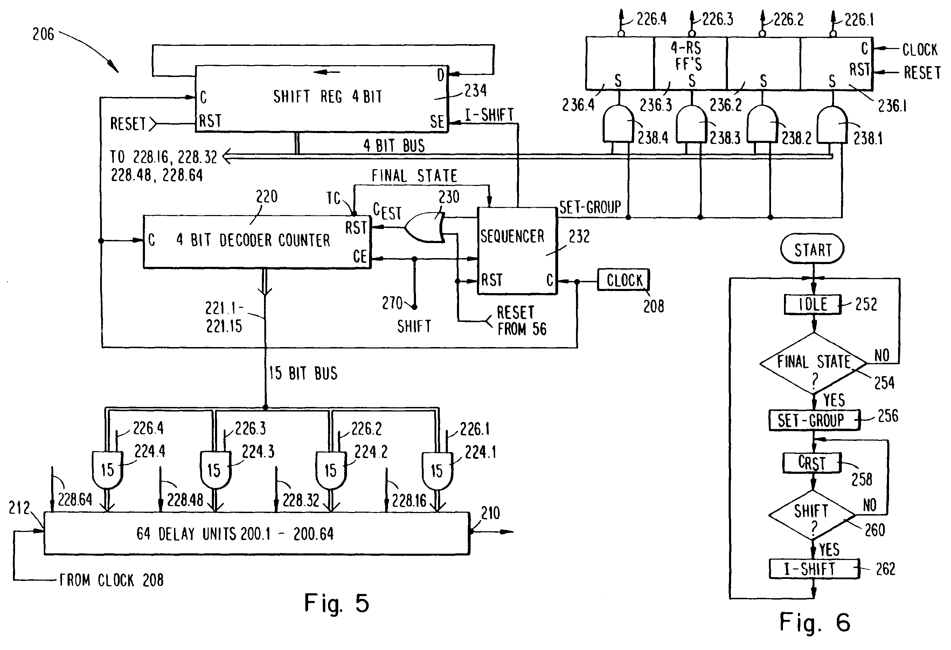

Fig. 5 is a schematic diagram of control unit 206 including four-bit, glitch-free decoded counter 220, e.g., a Gray code counter, AND gates 224.1-224.4, sequencer 232, four bit feedback shift register 234, synchronous set-reset flip-flops 236.1-236.4, and AND gates 238.1-238.4, all interconnected to control 64 delay units 200.1-200.64. Pulses from clock source 208 are supplied to clock inputs (C) of counter 220, sequencer 232, shift register 234 and flip-flops 236.1-236.4. Shift input pulses are supplied to count enable (CE) input of counter 220 and from sequencer 232 to the shift enable (SE) input of shift register 234. While thus enabled, counter 220 and shift register 234 respond to the leading edges of pulses from clock source 208 to increment the counter count and the shift register state.

Counter 220 has a decoded 15 bit output bus including lines 222.1-222.15. In the reset condition, all of lines 222.1-222.15 have binary one values thereon. One to zero transitions are sequentially supplied, in order, to lines 222.1-222.15 in response to 15 sequential shift pulses supplied to control unit 206 through terminal 270. Counter 220 is sequenced from state 0 to state 15 in response to 15 sequential shift pulses being applied to the count enable (CE) input thereof, followed by a pulse from clock 208 being applied to the clock (C) input of the counter. Because of the frequency offset between the output of clock 42 (equivalent to clock 208 in Fig. 3) and the frequency of the information supplied to input lines 12 and 14 (Fig. 1), there is a monotonic increase in the value of full adder 32, resulting in sequential, somewhat constant frequency shift output pulses on lead 34. Hence, there is a somewhat constant frequency change in the output of counter 220 on lines 222.1-222.15.

Lines 222.1-222.15 are supplied in parallel to inputs of gate arrays 224.1-224.4, each of which is associated with one of the four groups of delay units 200.1-200.64; each of gate arrays 224.1-224.4 includes 15 AND gates, one for each of delay units 200.1-200.15, 200.17-200.31, 200.33-200.47, and 200.49-200.63. AND gates 224.1-224.4 are disabled in response to binary 0 levels that are sequentially applied to the remaining input of each of the gates on leads 226.1-226.4, respectively.

Initially, flip-flops 236.1-236.4 are activated so a binary 1 level is derived on each of leads 226.1-226.4, to enable all of AND gates 224.1-224.4. In response to 16, 32, 48 and 64 shift pulses being supplied to controller 206 via terminal 270, the levels on leads 226.1-226.4 respectively change from 1 to 0 to sequentially disable AND gates 224.1-224.4. To these ends, each of AND gates 224.1-224.4 has a 15 bit output bus; each of the 15 bits is coupled to one of 15 different input terminals, each corresponding to terminal 228 of delay unit 200.(k) (Fig. 4). The separate bits of the 15 bit output buses of gates 224.1, 224.2, 224.3 and 224.4 are respectively connected to inputs corresponding to terminal 228 of delay units 200.1-200.15, 200.17-200.31, 200.33-200.47 and 200.49-200.63. Input terminals 228 of delay units 200.16, 200.32, 200.48 and 200.64 respectively respond to binary levels on leads 228.16, 228.32, 228.48 and 228.64, in turn responsive to binary levels loaded into the four stages of feedback shift register 234. Initially, shift register 234 is loaded with 0001 levels on leads 228.64, 228,48, 228,32 and 228.16, respectively. In response to every I-shift, the initially loaded binary one level shifts so it is sequentially applied to leads 228.16, 228.32, 228.48 and 228.64.

Counter 220 includes a reset input (RST), responsive to the reset output of phase change detector 56, as coupled through OR gate 230. OR gate 230 is also responsive to a reset output of programmed sequencer 232, that is advanced in response to pulses from clock source 208 and has a reset (RST) input responsive to the reset output of phase change detector 56.

Sequencer 232 includes an input from terminal TC of counter 220, having a binary 1 value in response to the counter being in the final state thereof. In the final state of counter 220, a binary 0 is applied to all of leads 221.1-221.15. Sequencer 232 also responds to the shift pulses at terminal 270. Sequencer 232 responds to the inputs thereof to derive output signals for controlling the application of pulses to leads 226.1-226.4, as well as to leads 228.16, 228.32, 228.48 and 228.64. To these ends, sequencer 232 supplies "I shift" pulses to shift enable (SE) input of shift register 234 and selectively feeds "set-group" pulses in parallel to set inputs of set-reset flip-flops 236.1, 236.2, 236.3 and 236.4 via AND gates 238.1, 238.2, 238.3 and 238.4, respectively. AND gates 238.1-238.4 are also respectively responsive to outputs from the four stages of shift register 234 so leads 228.16, 228.32, 228.48 and 228.64 are respectively connected to gates 238.1, 238.2, 238.3 and 238.4.

Shift register 234 is activated so stages 1-4 thereof are sequentially loaded with binary ones to sequentially enable gates 238.1-238.4 so the "set-group" output pulses of sequencer 232 are sequentially applied to the set (S) input terminals of flip-flops 236.1-236.4. This causes sequential binary 1 to 0 transitions on leads 226.1-226.4. All of flip-flops 236.1-236.4 are simultaneously reset to a 0 state in response to the reset output of phase change detector 56. Because leads 226.1-226.4 are connected to the inverting output terminals of flip-flops 236.1-236.4, binary ones are on leads 226.1-226.4 when the flip-flops are reset.

The last stage of four bit feedback shift register 234 is coupled back to the data (D) input of the shift register. Shift register 234 is activated to an initial condition in response to the reset output of phase change detector 56. In the reset condition, a binary 1 is in the first stage of shift register 234 and the remaining stages thereof are in a binary 0 state. Shift register 234 includes a shift enable (SE) input responsive to the I-shift output of sequencer 232 and an input clock terminal (C) responsive to the output of clock 208. Shift register 234 is constructed and responds to the inputs thereof so that the binary 1 in the first stage thereof is shifted to stages 2, 3 and 4 in response to 16, 32, 48 and 64 shift pulses (each followed by a pulse from clock source 208) supplied to terminal 270. Thereby, initially a binary 1 level is applied to isolation lead 228.16.

After 16 shift pulses, there is a binary 1 to 0 transition on lead 228.16 and a binary 0 to 1 transition is applied by the second stage of shift register 234 to lead 228.32. The binary 1 level remains on lead 228.32 until 32 shift pulses have been supplied to terminal 270. Operation continues in this manner for leads 228.48 and 228.64 unless a reset pulse is derived by detector 56 before the 64th shift pulse is derived.

A flow diagram for the operation of sequencer 232 is illustrated in Fig. 6. Sequencer 232 is activated sequentially and responds to the inputs thereof to derive the set-group, I-shift, and $C_{RST}$ outputs which are respectively applied to gates 238.1-238.4, the SE input of shift register 234 and the RST input of counter 220. In response to the reset input of sequencer 232 being supplied with a pulse from phase change detector 56, the sequencer is activated to idle state 252. The next pulse from clock 208 activates sequencer 232 to decision point 254 when a determination is made as to whether a binary 1 level is at the TC output of counter 220; a binary 1 at the TC output of counter 220 indicates that the counter is in its final state. If counter 220 is in its final state, sequencer 232 advances to "set-group" state 256, during which the sequencer supplies binary 1 levels in parallel to each of AND gates 238.1-238.4. The next clock pulse advances sequencer 232 to state 258. In state 258, sequencer 232 supplies a binary 1 level through OR gate 230 to the RST input of counter 220. The next pulse from clock source 208 advances sequencer 232 to decision point 260 when a determination is made as to whether a shift pulse is being supplied to control unit 206. If there is a shift pulse, the sequencer advances to state 262. In state 262, sequencer 232 supplies an "I-shift" pulse to the shift enable input of shift register 234. In response to the next clock pulse, sequencer 232 returns to idle state 252 and the cycle is repeated in response to the next set of clock pulses.

If at decision point 254 sequencer 232 determines that counter 220 is not in its final state, the sequencer stays in idle state 252. The sequencer stays in state 252 until a binary 1 level is at the TC output of counter 220, to indicate that the counter is in the final state. In response to decision point 260 determining that no shift pulse is being supplied to sequencer 232, sequencer 232 stays in state 258 and continuously resets counter 220 to the initial condition. Sequencer 232 stays in state 258 until a shift pulse is supplied to the sequencer via terminal 270.

In the reset state, binary 1 levels are supplied by control unit 206 to the terminal 228 of each of delay units 200.1-200.64, except for terminals 228 of delay units 200.32, 200.48 and 200.64. In the reset state, leads 226.1-226.4 supply binary 1 levels to AND gates 224.1-224.4, respectively, and counter 220 is activated so that a binary 1 is derived on each of output leads 222.1-222.15 thereof and the binary 1 in the first stage of shift register 234 is coupled to lead 228.16 connected to input terminal 228 of delay unit 200.16. Thereby, clock pulses from source 208 at terminal 212 are delayed in propagating from terminal 212 to terminal 210 by the delay time associated with delay unit 200.1.

The delay of delay unit 200.1 between terminals 212 and 210 for the pulses of clock source 208 is maintained until shift pulse 1 is supplied to count enable input (CE) of counter 220 and to an input of sequencer 232. In response to shift pulse 1 being followed by the leading edge of the next clock pulse from source 208, the state of counter 220 is incremented by a count 1. This causes the binary level at terminals 228 of delay units 200.1, 200.17, 200.33 and 200.49 to change from a binary 1 to a binary 0 state, while the binary level at the terminals 228 of the remaining delay units are unchanged. The change from a binary 1 to a binary 0 state at control terminals 228 of delay units 200.17, 200.33 and 200.49 has no effect on the delay imposed by delay circuit 198 on the output of clock 208. This is because an isolation level "1" is applied to lead 228.16 to open switch 202.16 and disconnect all of delay units 200.17-200.64 from delay units 200.1-200.16 that are effectively in the circuit.

With delay units 200 set as stated, pulses from clock source 208 are delayed by the delay time of delay units 200.1 and 200.2. The binary 0 level applied to control terminal 228 of delay unit 200.1 prevents coupling of the pulse from clock source 208 through OR gate 213 of delay unit 200.1. The binary 1 level applied to control terminal 228 of delay unit 200.2 causes the pulse from clock source 208 to be coupled, with the delay time associated with delay unit 200.2, through OR gate 213 and AND gate 215 to terminal 216 of delay unit 200.2. The pulse at output terminal 216 of delay unit 200.2 is coupled to terminal 217 of delay unit 200.1, thence to output terminal 216 of delay unit 200.1 with an interposed delay of delay unit 200.1. Thereby, the clock pulse from source 208 is coupled from terminal 212 to terminal 210 with the combined interposed delays of delay units 200.1 and 200.2.

Operation continues in this manner for delay units 200.1-200.15 in response to counter 220 being incremented by the first 15 successive shift pulses. At this point the counter reaches its final state. This causes a binary 1 level to be supplied by the TC output of counter 220 to sequencer 232 to advance the sequencer to "set-group" state 256 in response to a pulse from clock source 208. With sequencer 232 in state 256, a binary 1 level is supplied by the sequencer in parallel to each of AND gates 238.1-238.4.

In response to the next clock pulse from source 208, sequencer 232 advances to reset state 258, to reset counter 220 to the initial condition of a binary 1 level being in all stages of the counter, so that binary 1 levels are supplied to each of leads 222.1-222.15. The next pulse from clock source 208 advances sequencer 232 to decision point 260, where it detects the presence or absence of a shift pulse at terminal 270. In response to shift pulse 16, sequencer 232 advances to state 262 and supplies a binary 1 level to shift enable (SE) input of shift register 234. This causes a binary 1 level to be loaded into the second stage of the shift register, while each of stages 1, 3 and 4 of the shift register is loaded with a binary 0.

While sequencer 232 is in state 256 as a result of counter 220 being sequenced in response to 15 shift pulses, flip-flop 236.1 is set to 1, causing the level on lead 226.1 to change from a binary 1 to a binary 0. This change occurs because the binary 1 state of the first stage of shift register 234 is coupled through AND gate 238.1 to flip-flop 236.1. In response to the level on lead 226.1 being at the binary 0 level, AND gate 224.1 is disabled and binary 0 levels are applied to input terminals 228 of delay units 220.1-220.15 until the next reset pulse is derived by detector 56.

A binary 1 level is applied to input terminal 228 of delay unit 200.16 until shift pulse 16 is applied to control unit 206, followed by a clock pulse. This is because the first stage of shift register 234 remains in a binary 1 state during the interval of shift pulses 1-15. Shift pulse 16 and the following clock pulse from source 208 cause the first stage of shift register 234 to change from the binary 1 state to the binary 0 state. At the same time the second stage of the shift register is loaded with a binary 1, while the remaining stages of the shift register are loaded with binary 0 states. This causes a binary 1 to 0 transition on lead 228.16 so delay unit 200.16 is inserted between terminals 212 and 210. The total delay time between terminals 212 and 210 for the pulses of clock source 208 becomes the combined delay times of delay units 200.1-200.16. After operation 262, sequencer 232 is activated by the next clock pulse from source 208, to return to idle state 252.

Hence, after the 16th shift pulse has been supplied to sequencer 232 and counter 220, followed by the next pulse from clock source 208, binary 0 levels are supplied to the control terminals 228 of delay units 200.1-200.16. At this time, binary 1 levels are supplied by flip-flops 236.2-236.4 to AND gates 224.2-224.4, respectively, and by counter 220 to leads 222.1-222.15. Thereby, binary 1 levels are supplied to input terminals 228 of delay units 200.17-200.64, except for delay units 200.48 and 200.64 which are supplied with binary 0 levels.

Operation continues in the stated manner for the remaining delay units 200.17-200.64 in response to shift pulses 17-64, until a reset pulse is supplied by phase change detector 56 to control unit 206. In many instances, a reset pulse is supplied by phase change detector 56 to control unit 206 considerably prior to the level at terminal 228 of control unit 200.64 changing from a binary 1 to a binary 0 level. The time when the reset pulse is derived, relative to the change of state at a particular delay unit 200, is random and variable, as a function of manufacturing tolerances, temperature and supply voltage of the delay units. In any event, it is necessary for the total delay time of delay units 200.1-200.64, when cascaded together, to exceed the period between adjacent pulses of clock source 208. In response to the reset pulse from phase change detector 56, counter 220, sequencer 232, shift register 234 and flip-flops 236.1-236.4 are activated to the initial conditions, previously described. The sequence then begins anew in response to the next shift pulse at terminal 270.

Although specific embodiments have been described in illustration of the invention, it will be understood that variations and modifications thereof, as well as other embodiments may be made within the scope of the protection sought by the appended claims.

**Claims**

1. A method of shifting the phase of a first periodic waveform (42) to a selected one of at least several different discrete values (output of 36), comprising imposing a delay (44.1, 44.2 ...44.N) on the periodic waveform (4) for a time determined by the selected discrete value to derive another periodic waveform (46), that is phase shifted with respect to the first periodic waveform so that as the selected discrete value changes the imposed delay changes, characterized in that the selected discrete value is reset (reset of 36) to an initial value in response to the first periodic waveform (42) being shifted by the imposed delay through an integral multiple of about one cycle of the first periodic waveform (42).

2. The method of claim 1 wherein said initial value is equal to zero.

3. The method of any of the preceding claims wherein the selected discrete value is derived by

   converting (36) a value representing a desired phase delay (output of 32) of the periodic waveform (42) into a signal (output of 36) having at least several discrete values that change as a function of time, and
   incrementing (output of 28) the discrete value of the signal at a certain rate for every unit of desired phase delay change in a cycle of the periodic waveform (42),
   the imposed delay being established by establishing at least several discrete delay times (44) for the periodic waveform (42),
   selecting (40) one of the at least several discrete delay times of the periodic waveform (42) in response to the discrete value of the signal so there is a correspondence between the discrete delay times to which the periodic waveform (42) is subjected and the changing values of the discrete signal,
   delaying (44) the periodic waveform (42) by the selected discrete delay time to derive a delay-subjected periodic waveform (46); and
   performing the resetting by resetting (36) the discrete value of the signal to a predetermined value in response to the phase of the delayed subjected periodic waveform changing over approximately an integral multiple of 360° of the phase of the periodic waveform (42).

4. The method of any of the preceding claims wherein the periodic waveform (42) is a clock wave having a predetermined fixed frequency, the phase-shifted periodic waveform being an output wave (output of 50),

deriving (16, 18, 22, 28) a digital control signal having a value that varies in response to the relative phase of a constant frequency input signal (12, 14) and the output wave (46),

subjecting the clock wave to the at least several discrete delays (44) so there are derived at least several waves having differing time positions that are replicas of the clock wave,

the delay being imposed by selecting (40) one of the waves having differing time positions in response to the values of the digital control signal (output of 36) to derive the output wave, and

the resetting (output of 56) causing resetting of the value of the digital control signal to a predetermined initial value therefor each time the output wave (output of 50) changes phase relative to the clock wave (42) by approximately 360° due to a lead/lag change in the phase relationship of the output wave and clock wave.

5. The method of claim 4 wherein the output wave and input signal are such that the digital control signal value (output of 36) changes monotonically between resets.

6. The method of any of the preceding claims wherein the imposed delay is provided by applying the periodic waveform (208) to at least several cascaded delay units (200) having discrete delay times, the discrete values changing the number of the cascaded delay units connected to the periodic waveform so that as the signal value (output of 206) changes, the cascaded delay units are connected to and disconnected (by 202 and 204) from the periodic waveform (208).

7. The method of any of the preceding claims wherein the periodic waveform is a clock and the method attains a phase lock between a constant frequency input (12, 14) and the clock (42) which has a frequency slightly different from the constant frequency, further comprising sampling (16,18) the amplitude of the input at a sampling frequency (output of 50) resulting from the phase shifted clock, responding to the sampled amplitude (output of 16, 18) to derive a first representation (output of 28) having a value equal to a frequency error between the sampling frequency and the constant frequency input, integrating (32) the first representation to derive a second representation having a value commensurate with the phase shift to be imposed on the clock, the imposed phase shift (by 40, 44) shifting the frequency of the clock (42), adjacent ones of said phase shift values being approximately equally spaced from each other, the delay imposed on the clock (by 40, 44) being for a time directly proportional to a selected one of the discrete values to derive the frequency shifted clock (output of 50).

8. The method of claim 7 wherein the delay is imposed by deriving (44) at least several replicas of the clock such that adjacent replicas k (outputs of 44.1 and 44.2) are time delayed from each other by approximately the same amount, and selecting (by 40) the replica that is phase shifted from the clock by an amount determined by the value of the second representation (output of 32).

9. Apparatus for shifting the phase of a periodic waveform (42) in response to a control signal (output of 36) representing a phase change to be applied to the periodic waveform comprising a circuit (44) responsive to the periodic waveform (42) for deriving at least several replicas of the periodic waveform (outputs of 44.1...44.(N-1)), the replicas having different time delays with respect to each other, means (40) responsive to the phase change representing signal (output of 36) for coupling a selected one of the replicas to a first output terminal (46) as a function of the value of the control signal, characterized by means (56) for resetting the control signal (output of 36) to the predetermined value when the replica, at the output terminal (46) has shifted through an integral multiple of about one cycle of the periodic waveform (42).

10. The apparatus of claim 9 wherein the phase change representing signal is a phase correction signal (34) derived in response to a signal representing a substantially constant frequency error (30) between the replica at the output terminal and a reference frequency (12), the predetermined value of the control signal being set to a value associated with a phase delay of 0° for the periodic waveform (42) when the replica at the output terminal has a phase that differs by approximately Px360° from the phase of the periodic waveform after being supplied to the first output terminal (46), where P is an integer.

11. The apparatus of any of claims 9-10 wherein the means for resetting has a finite propagation delay (58), the means for resetting including means (56) for detecting the simultaneous occurrence of like transitions in the selected replica at the output terminal (46) and a replica of the clock (output of 58) as delayed by the propagation delay.

12. The apparatus of any of claims 9-11 wherein the circuit includes at least several delay units (44) having discrete delay times, and further including a controller (40) responsive to the control signal (output of 36) for controlling connections of the delay units (44) between an output terminal of a source of the waveform (42) and the first output terminal (46) so that as the value of the control signal changes there are corresponding changes in the delay time interposed by the delay units on the periodic waveform between the waveform source output terminal and the first output terminal, the delay units (44) being cascaded with each other, the controller (40) responding to the value of the control signal for effectively controlling the number of the delay units cascaded between the source output terminal and the another output terminal so that as the value of the control signal changes there are corresponding changes in the number of the delay units effectively cascaded between the output terminals, the controller selecting an output of one of the delay units and coupling to it the first output terminal.

13. The apparatus of claim 12 wherein the controller includes a multiplexer (40) having a first input terminal (38) responsive to the control signal for selecting an output of one of the delay units and coupling it to the another output terminal (46), the multiplexer having 1,2 ... N signal input terminals (0 ... (N-1)) respectively responsive to 1,2 ... N delayed replicas of the wave at output terminals of delay units 1,2 ... N, the delay time of the delayed replica at input terminal k exceeding the delay time of the delayed replicas at input terminals 1,2 ... (k-1), where k is respectively each of 2 ... N, the control signal to which the multiplexer is responsive being an M bit digital reflected coded signal (output of 36) having a value indicating the phase shift to be introduced between the waveform source output terminal and the another output terminal, the another output terminal being an output terminal of the multiplexer, the multiplexer including (N-1) gates (70) each having: (a) first and second signal inputs (A and B), (b) a signal output and (c) a control input (S) responsive to a bit of the reflected coded signal (output of 36) for routing the signal at one of the two signal inputs (A and B) to the signal output as a function of the bit value at the control input (S); the signal inputs and signal outputs of the gates (70) being connected to (a) each other, (b) the multiplexer (40) input terminals and (c) the multiplexer output terminal (46) and the control inputs of the gates being connected to be responsive to the M bits of the M bit digital reflected coded signal so that, as the reflected signal value changes from a reflected value representing the value in base 10 of i to (i+1), the signal at the multiplexer input terminal i changes to the signal at multiplexer input terminal (i+1), where i is selectively each of 0,1,2 ... (N-2).

14. The apparatus of any of claims 9-11 wherein the phase shift is interposed between an output terminal (212) of a source (208) of the waveform and the first output terminal (output of 200.1), the circuit including at least several delay units 1,2 ... N (200) having discrete delay times, a control means (202, 204, 206) responsive to the value of the control signal (output of 220) for controlling connections of the delay units between the waveform source output terminal and the another output terminal so that as the value of the control signal changes there are corresponding changes in the delay time interposed by the delay units (200) on the periodic waveform between the source of the waveform output terminal and the first output terminal, the delay units being cascaded with each other, the control means (202, 204, 206) responding to the value of the control signal for effectively controlling the number of the delay units cascaded between the source output terminal (212) and the first output terminal (output of 200.1) so that as the value of the control signal changes there are corresponding changes in the number of the units effectively cascaded between the another output terminal and the output terminals of said delay units 1,2 ... N, delay unit 1 (200.1) being connected so an output thereof is connected to said first output terminal without connections through any other of said N delay units, the control means controlling connections (provided by 202, 204) between input and output terminals of the delay units and between the source output terminal (212) and the input terminal of said delay unit 1 so that in response to the control signal having a value commanding k of said delay units to be cascaded between the source output terminal (212) and the first output terminal the input terminal of delay unit k is connected to the source output terminal without connections through any other of said N delay elements, and the output terminal of delay unit j is connected to the input terminal of delay unit (j-1), where k is selectively any integer between 2 and N and j is selectively every integer between 2 and k.

15. The apparatus of claim 14 wherein the control means establishes a connection (202.(k-1)) between delay units k and (k-1) before breaking a connection between an input of delay unit (k-1) and the waveform source terminal in response to the number of delay units interposed between the source output terminal and the another output terminal changing from k to (k-1).

16. The apparatus of any of claims 9-15 wherein the apparatus is included in a phase locked loop (Fig. 1) including an analog-to-digital converter (16,18) responsive to an intelligence representing set of bits (12,14), at least a portion of the intelligence having a tendency to be degraded, the converter deriving a multibit digital signal representing an amplitude of the intelligence in response to a sampling wave train (output of 50) derived in response to the shifted periodic waveform at the first output terminal, and means (22,28,32) responsive to the converter for deriving signals representing frequency (output of 28) and phase (output of 32) errors between the intelligence and the shifted periodic waveform at the first output terminal; the signal representing the phase error controlling the control signal.

17. The apparatus of any of claims 9-16 wherein the first output terminal and the frequency of the periodic waveform and the value of the control signal and the apparatus are such that the number of effective delay units between the source output terminal and the first output terminal always changes monotonically as a function of time.

18. The apparatus of any of claims 9-17 wherein the apparatus is included in a variable frequency oscillator, the apparatus further comprising: a command source (output of 28) for changing the frequency of the oscillator, a signal value derived by the command source being 0 for a constant frequency output of the oscillator at the first output terminal and being other than 0 for changes in the oscillator output frequency, and means for integrating (32) the value derived by the command source to control the amount of the delay time interposed by the delay units on the periodic waveform.

19. The apparatus of claim 14 wherein the control means (205) divides the N elements into plural groups (each group is associated with one of 224.1-224.4), the control means monotonically changing the value of k from 1 to P for a first group of P of the N elements during a first time interval, and then monotonically changing the value of k from 1 to Q for a second group of Q of the elements during a second time interval, where P and Q are integers less than N.

20. The apparatus of claim 19 wherein the control means includes a counter (220) having P states that are sequenced from 1 to P, and a coupler (224.1-224.4) for coupling control signals indicative of which of the P states the counter is in from the counter to the first group of P elements during the first time interval and for coupling control signals indicative of which of the Q states the counter is in from the counter to the second group of Q elements during the second time interval, where Q is greater than P.

21. The apparatus of any of claims 9-20 wherein the control signal represents frequency corrections (output of 28) to be applied to the periodic waveform and a controller (32, 36, 40) responds to the value of the frequency correction signal for coupling the periodic waveform as delayed by the discrete time delays to the first output terminal (46) so that when the value of the frequency correction is not zero there are corresponding changes in the discrete time delays of the periodic waveform at the first output terminal and when the value of the frequency correction is zero the phase of the delayed periodic waveform at the first output terminal does not change and is susceptible of having all of the discrete time delays, the frequency correction signal being very small to thereby change the phase of the delayed periodic waveform at the first output terminal relative to the periodic waveform as applied to the delay circuit after many cycles of the periodic waveform have occurred.

22. The apparatus of any of claims 9-21 wherein the circuit when switched in response to the phase change control signal has a tendency to derive a glitch at another output terminal (output of 50), and a circuit (48) coupled to the another output terminal for preventing the coupling of the glitches to the another output terminal.

23. The apparatus of any of claims 9-22 wherein the control signal is set to the predetermined value therefor by sensing a lead/lag change in the phase relationship of the selected replica and the periodic waveform.

**Patentansprüche**

1. Verfahren zum Verschieben der Phase einer ersten periodischen Wellenform (42) auf einen ausgewählten von mindestens einigen verschiedenen diskreten Werten (Ausgang von 36), wobei der periodischen Wellenform (42) eine Verzögerung (44.1, 44.2...44.N) über eine von dem ausgewählten diskreten Wert bestimmte Zeit auferlegt wird, um eine weitere periodische Wellenform (46) zu gewinnen, die bezüglich der ersten periodischen Wellenform in ihrer Phase verschoben ist, so daß sich die auferlegte Verzögerung ändert, wenn sich der ausgewählte diskrete Wert ändert, dadurch **gekennzeichnet**, daß der gewählte diskrete Wert in Antwort darauf, daß die erste periodische Wellenform (42) durch die auferlegte Verzögerung über ein ganzes Vielfaches etwa eines Zyklus der ersten periodischen Wellenforn (42) verschoben wird, auf einen Anfangswert zurückgesetzt wird (Zurücksetzen von 36).

2. Verfahren nach Anspruch 1, wobei der genannte Anfangswert gleich Null ist.

3. Verfahren nach einem der vorhergehenden Ansprüche, wobei der gewählte diskrete Wert wie folgt erhalten wird:

Umwandeln (36) eines eine gewünschte Phasenverzögerung (Ausgang von 32) der periodischen Wellenform (42) darstellenden Werts in ein Signal (Ausgang von 36) mit mindestens einigen diskreten Werten, die sich als Funktion der Zeit ändern, und Erhöhen (Ausgang von 28) des diskreten Werts des Signals mit einer gewissen Geschwindigkeit für jede Einheit einer gewünschten Phasenverzögerungsänderung in einem Zyklus der periodischen Wellenform (42), wobei die auferlegte Verzögerung erhalten wird, indem mindestens einige diskrete Verzögerungszeiten (44) für die periodische Wellenform (42) vorgesehen werden, in Antwort auf den diskreten Wert des Signals eine der mindestens einigen diskreten Verzögerungszeiten der periodischen Wellenform (42) so ausgewählt wird (40), daß eine Entsprechung zwischen den diskreten Verzögerungszeiten, denen die periodische Wellenform (42) unterworfen wird, und den sich ändernden Werten des diskreten Signals besteht, die periodische Wellenform (42) um die gewählte diskrete Verzögerungszeit verzögert wird (44), um eine einer Verzögerung unterworfene periodische Wellenform (46) zu gewinnen; und das Zurücksetzen durch Zurücksetzen (36) des diskreten Werts des Signals auf einen vorbestimmten Wert in Antwort darauf geschieht, daß sich die Phase der einer Verzögerung unterworfenen periodischen Wellenform über etwa ein ganzzahliges Vielfaches von 360° der Phase der periodischen Wellenform (42) ändert.

4. Verfahren nach einem der vorhergehenden Ansprüche, wobei die periodische Wellenform (42) eine Taktwelle mit einer vorbestimmten festen Frequenz darstellt und die phasenverschobene periodische Wellenform eine Ausgangswelle (Ausgang von 50) ist,

ein digitales Steuersignal mit einem Wert erhalten wird (16, 18, 22, 28), der sich in Antwort auf die relative Phase eines Eingangssignals (12, 14) konstanter Frequenz und der Ausgangswelle (46) verändert, die Taktwelle den mindestens einigen diskreten Verzögerungen (44) unterworfen wird, so daß mindestens einige Wellen mit unterschiedlichen zeitlichen Positionen abgeleitet werden, die Replikationen der Taktwelle sind, das Auferlegen der Verzögerung durchgeführt wird, indem in Antwort auf die Werte des digitalen Steuersignals (Ausgang von 36) eine der Wellen mit unterschiedlichen zeitlichen Positionen ausgewählt wird (40), um die Ausgangswelle zu gewinnen, und das Zurücksetzen (Ausgang von 56) jedesmal dann, wenn die Ausgangswelle (Ausgang von 50) aufgrund einer Vorlauf/Rücklauf-Änderung in der Phasenbeziehung der Ausgangswelle und der Taktwelle ihre Phase bezüglich der Taktwelle (42) um etwa 360° ändert, ein Zurücksetzen des Werts des digitalen Steuersignals auf einen vorbestimmten Anfangswert des digitalen Steuersignals bewirkt.

5. Verfahren nach Anspruch 4, wobei die Ausgangswelle und das Eingangssignal so eingerichtet sind, daß sich der Wert des digitalen Steuersignals (Ausgang von 36) zwischen Zurücksetzvorgängen monoton ändert.

6. Verfahren nach einem der vorhergehenden Ansprüche, wobei die auferlegte Verzögerung durch Anwenden mindestens einiger verketteter Verzögerungseinheiten (200) mit diskreten Verzögerungszeiten auf die periodische Wellenform (208) bewirkt wird und die diskreten Werte die Zahl der mit der periodischen Wellenform verbundenen Verzögerungseinheiten so ändern, daß dann, wenn sich der Signalwert (Ausgang von 206) ändert, die verketteten Verzögerungseinheiten mit der periodischen Wellenform (208) verbunden und von ihr getrennt werden (durch 202 und 204).

7. Verfahren nach einem der vorhergehenden Ansprüche, wobei die periodische Wellenform einen Takt darstellt und das Verfahren eine Phasenverriegelung zwischen einer Eingabe (12, 14) konstanter Frequenz und dem Takt (42) erreicht, der eine von der konstanten Frequenz leicht verschiedene Frequenz aufweist, und wobei das Verfahren außerdem das Abtasten (16, 18) der Amplitude der Eingabe mit einer sich aus dem phasenverschobenen Takt ergebenden Abtastfrequenz (Ausgang von 50), das Reagieren auf die abgetastete Amplitude (Ausgang von 16, 18) unter Gewinnung einer ersten Darstellung (Ausgang von 28) mit einem einem Frequenzfehler zwischen der Abtastfrequenz und der Eingabe konstanter Frequenz entsprechenden Wert, und das Integrieren (32) der ersten Darstellung unter Gewinnung einer zweiten Darstellung mit einem der dem Takt aufzuerlegenden Phasenverschiebung (durch 40, 44), die die Frequenz des Takts (42) verschiebt, vergleichbaren Wert beinhaltet, wobei benachbarte Phasenverschiebungswerte einen etwa gleichförmigen Abstand voneinander aufweisen und die dem Takt (durch 40, 44) auferlegte Verzögerung über eine Zeit erfolgt, die einem ausgewählten der diskreten Werte direkt proportional ist, um den frequenzverschobenen Takt (Ausgang von 50) zu erhalten.

8. Verfahren nach Anspruch 7, wobei die Verzögerung durch Gewinnen (44) mindestens einer Replikation des Takts, so daß benachbarte Replikationen k (Ausgänge von 44.1 und 44.2) etwa die gleiche Zeitverzögerung voneinander aufweisen, und durch Wählen (durch 40) derjenigen Replikation, die gegenüber dem Takt um einen Betrag phasenverschoben ist, der vom Wert der zweiten Darstellung (Ausgang von 32) bestimmt ist, erfolgt.

9. Vorrichtung zum Verschieben der Phase einer periodischen Wellenform (42) in Antwort auf ein Steuersignal (Ausgang von 36), das eine der periodischen Wellenform aufzuerlegende Phasenänderung darstellt, aufweisend:

eine auf die periodische Wellenform (42) ansprechende Schaltung (44), um mindestens einige Replikationen der periodischen Wellenform (Ausgänge von 44.1...44.(N-1)) zu gewinnen, die jeweils zueinander unterschiedliche Zeitverzögerungen aufweisen, eine auf das die Phasenänderung darstellende Signal (Ausgang von 36) ansprechende Einrichtung (40) zum Verbinden einer ausgewählten Replikation mit einem ersten Ausgangsanschluß (46) als Funktion des Werts des Steuersignals, gekennzeichnet durch eine Einrichtung (56) zum Zurücksetzen des Steuersignals (Ausgang von 36) auf einen vorbestimmten Wert, wenn sich die Replikation an dem Ausgangsanschluß (46) über ein ganzes Vielfaches etwa eines Zyklus der periodischen Wellenform (42) verschoben hat.

10. Vorrichtung nach Anspruch 9, wobei das die Phasenänderung darstellende Signal ein Phasenkorrektursignal (34) ist, das aufgrund eines einen im wesentlichen konstanten Frequenzfehler (30) zwischen der Replikation an dem Ausgangsanschluß und einer Bezugsfrequenz (12) darstellenden Signals gewonnen wird, wobei der vorbestimmte Wert des Steuersignals auf einen Wert gesetzt ist, der einer Phasenverzögerung von 0° der periodischen Wellenforn (42) entspricht, wenn sich die Phase der Replikation am Ausgangsanschluß von der Phase der periodischen Wellenform nach Lieferung an den ersten Ausgangsanschluß (46) um etwa Px360° unterscheidet, wobei P eine ganze Zahl darstellt.

11. Vorrichtung nach einem der Ansprüche 9 bis 10, wobei die Zurücksetzungseinrichtung eine endliche Laufzeitverzögerung (58) aufweist und eine Einrichtung (56) zum Erkennen eines gleichzeitigen Auftretens ähnlicher Übergänge in der ausgewählten Replikation am Ausgangsanschluß (46) und einer von der Laufzeitverzögerung verzögerten Replikation des Takts (Ausgang von 58) beinhaltet.

12. Vorrichtung nach einem der Ansprüche 9 bis 11, wobei die Schaltung mindestens einige Verzögerungseinheiten (44) mit diskreten Verzögerungszeiten und eine Steuerung (40) aufweist, die auf das Steuersignal (Ausgang von 36) anspricht, um Verbindungen der Verzögerungseinheiten (44) zwischen einem Ausgangsanschluß einer Quelle der Wellenforn (42) und dem ersten Ausgangsanschluß (46) so zu steuern, daß dann, wenn sich der Wert des Steuersignals ändert, entsprechende Änderungen der der periodischen Wellenform zwischen dem Ausgangsanschluß der Wellenform-Quelle und dem ersten Ausgangsanschluß von den Verzögerungseinheiten auferlegten Verzögerungszeit auftreten, wobei die Verzögerungseinheiten (44) miteinander verkettet sind, die Steuerung (40) auf den Wert des Steuersignals anspricht, um die wirksame Zahl der zwischen dem Ausgangsanschluß der Quelle und dem anderen Ausgangsanschluß verketteten Verzögerungseinheiten so zu steuern, daß dann, wenn sich der Wert des Steuersignals ändert, entsprechende Änderungen in der Zahl der zwischen den Ausgangsanschlüssen wirksam verketteten Verzögerungseinheiten auftreten, und die Steuerung einen Ausgang einer der Verzögerungseinheiten auswählt und den ersten Ausgangsanschluß mit ihn verbindet.

13. Vorrichtung nach Anspruch 12, wobei die Steuerung einen Multiplexer (40) mit einem auf das Steuersignal ansprechenden ersten Eingangsanschluß (38) aufweist, um einen Ausgang einer der Verzögerungseinheiten zu wählen und ihn mit dem anderen Ausgangsanschluß (46) zu verbinden, der Multiplexer 1,2...N Signal-Eingangsanschlüsse (0...(N-1)) aufweist, die jeweils auf 1,2...N verzögerte Replikationen der Welle an Ausgangsanschlüssen von Verzögerungseinheiten 1,2...N ansprechen, die Verzögerungszeit der verzögerten Replikation am Eingangsanschluß k die Verzögerungszeit der verzögerten Replikationen an Eingangsanschlüssen 1,2...(k-1) übersteigt, wobei k jeweils 2...N annimmt, das Steuersignal, auf das der Multiplexer anspricht, ein reflektiertes M-Bit Digitalcodesignal (Ausgang von 36) mit einem Wert, der die zwischen dem Ausgangsanschluß der Wellenforn-Quelle und dem anderen Ausgangsanschluß einzufügenden Phasenverschiebung anzeigt, darstellt, der andere Ausgangsanschluß ein Ausgangsanschluß des Multiplexers ist, der Multiplexer (N-1) Gatter (70) beinhaltet, die jeweils aufweisen: (a) einen ersten und einen zweiten Signaleingang (A und B), (b) einen Signalausgang und (c) einen auf ein Bit des reflektierten Codesignals (Ausgang von 36) ansprechenden Steuereingang (S), um das Signal an einem der beiden Signaleingänge (A und B) als Funktion des Bitwerts am Steuereingang (S) dem Signalausgang zuzuleiten; wobei die Signaleingänge und Signalausgänge der Gatter (70) (a) miteinander, (b) mit den Eingangsanschlüssen des Multiplexers (40) und (c) mit dem Ausgangsanschluß (46) des Multiplexers verbunden sind und die Steuereingänge der Gatter so angeschlossen sind, daß sie auf die M-Bits des reflektierten M-Bit-Digitalcodesignals auf solche Weise ansprechen, daß dann, wenn sich der Wert des reflektierten Signals von einem reflektierten Wert, der in der Basis 10 dem Wert i entspricht, auf (i+1) ändert, das Signal am Eingangsanschluß i des Multiplexers sich zum Signal am Eingangsanschluß (i+1) des Multiplexers ändert, wobei i wahlweise jeweils 0,1,2...(N-2) ist.

14. Vorrichtung nach einem der Ansprüche 9 bis 11, wobei die Phasenverschiebung zwischen einem Ausgangsanschluß (212) einer Quelle (208) der Wellenform und dem ersten Ausgangsanschluß (Ausgang von 200.1) vorgenommen wird, die Schaltung mindestens einige Verzögerungseinheiten 1,2...N (200) mit diskreten Verzögerungszeiten sowie eine Steuereinrichtung (202, 204, 206) beinhaltet, die auf den Wert des Steuersignals (Ausgang 220) anspricht, um Verbindungen der Verzögerungseinheiten zwischen dem Ausgangsanschluß der Wellenform-Quelle und dem anderen Ausgangsanschluß so zu steuern, daß dann, wenn sich der Wert des Steuersignals ändert, entsprechende Änderungen in der Verzögerungszeit auftreten, die der periodischen Wellenform zwischen der Quelle des Ausgangsanschlusses der Wellenform und dem ersten Ausgangsanschluß durch die Verzögerungseinheiten (200) auferlegt wird, wobei die Verzögerungseinheiten miteinander verkettet sind, die Steuereinrichtung (202, 204, 206) auf den Wert des Steuersignals anspricht, um die effektive Zahl der zwischen dem Ausgangsanschluß (202) der Quelle und dem ersten Ausgangsanschluß (Ausgang von 200.1) verketteten Verzögerungseinheiten so zu steuern, daß dann, wenn sich der Wert des Steuersignals ändert, entsprechende Änderungen in der Zahl der zwischen dem anderen Ausgangsanschluß und den Ausgangsanschlüssen der Verzögerungseinheiten 1,2...N wirksam verketteten Einheiten auftreten, die Steuereinheit 1 (200.1) so verbunden ist, daß ein Ausgang von ihr ohne Verbindung über irgendeine andere der N Verzögerungseinheiten mit dem ersten Ausgangsanschluß verbunden ist, die Steuereinheit Verbindungen (durch 202, 204) zwischen Eingangs- und Ausgangsanschlüssen der Verzögerungseinheiten und zwischen dem Ausgangsanschluß (212) der Quelle und dem Eingangsanschluß der genannten Verzögerungseinheit 1 so steuert, daß ansprechend auf ein Steuersignal mit einem Wert, der eine Verkettung von k der Verzögerungseinheiten zwischen dem Ausgangsanschluß (212) der Quelle und dem ersten Ausgangsanschluß verlangt, der Eingangsanschluß der Verzögerungseinheit k ohne Verbindung über irgendeine andere der N Verzögerungseinheiten mit dem Ausgangsanschluß der Quelle verbunden wird und der Ausgangsanschluß der Verzögerungseinheit j mit dem Eingangsanschluß der Verzögerungseinheit (j-1) verbunden wird, wobei k wahlweise irgendeine ganze Zahl zwischen 2 und N und j wahlweise jede ganze Zahl zwischen 2 und k ist.

15. Vorrichtung nach Anspruch 14, wobei die Steuereinrichtung darauf ansprechend, daß sich die Zahl der zwischen dem Ausgangsanschluß der Quelle und dem anderen Ausgangsanschluß zwischenliegenden Verzögerungseinheiten von k auf (k-1) ändert und vor dem Unterbrechen einer Verbindung zwischen einem Eingang der Verzögerungseinheit (k-1) und dem Anschluß der Wellenform-Quelle eine Verbindung (202.(k-1)) zwischen den Verzögerungseinheiten k und (k-1) herstellt.

16. Vorrichtung nach einem der Ansprüche 9 bis 15, die in einer phasenverriegelten Schleife (Figur 1) enthalten ist, die einen Analog-zu-Digital-Wandler (16, 18) beinhaltet, der auf einen Satz an Bits (12, 14) anspricht, der Informationen darstellt, von denen mindestens ein Teil zum Qualitätsverlust neigt, wobei der Wandler auf einen Abtast-Wellenzug (Ausgang von 50) anspricht, der in Antwort auf die verschobene periodische Wellenform an dem ersten Ausgangsanschluß gewonnen wird, und ein eine Amplitude der Informationen darstellendes Mehrbit-Digitalsignal gewinnt, wobei die phasenverriegelte Schleife eine Einrichtung (22, 28, 32) aufweist, um auf den Wandler ansprechend Signale zu gewinnen, die einen Frequenz-(Ausgang von 28) und einen Phasenfehler (Ausgang von 32) zwischen den Informationen und der verschobenen periodischen Wellenform an dem ersten Ausgangsanschluß darstellen; wobei das den Phasenfehler darstellende Signal das Steuersignal steuert.

17. Vorrichtung nach einem der Ansprüche 9 bis 16, wobei der erste Ausgangsanschluß und die Frequenz der periodischen Wellenforn und der Wert des Steuersignals und die Vorrichtung so eingerichtet sind, daß sich die Zahl der wirksamen Verzögerungseinheiten zwischen dem Ausgangsanschluß der Quelle und dem ersten Ausgangsanschluß als Funktion der Zeit stets monoton ändert.

**18.** Vorrichtung nach einem der Ansprüche 9 bis 17, die in einem Oszillator variabler Frequenz enthalten ist und außerdem aufweist:

> eine Befehlsquelle (Ausgang von 28) zum Ändern der Frequenz des Oszillators, wobei ein von der Befehlsquelle gewonnener Signalwert für eine konstante Frequenzausgabe des Oszillators an dem ersten Ausgangsanschluß 0 und für Änderungen der Ausgangsfrequenz des Oszillators von 0 verschieden ist, sowie eine Einrichtung zum Integrieren (32) des von der Befehlsquelle gewonnenen Werts, um den Wert der der periodischen Wellenforn von den Verzögerungseinheiten auferlegten Verzögerungszeit zu steuern.

**19.** Vorrichtung nach Anspruch 14, wobei die Steuereinrichtung (205) die N Elemente in mehrere Gruppen teilt (Gruppen jeweils in Zuordnung zu 224.1 bis 224.4), die Steuereinrichtung für eine erste Gruppe von P der N Elemente während einer ersten Zeitspanne den Wert von k monoton von 1 bis P und dann für eine zweite Gruppe von Q der Elemente während einer zweiten Zeitspanne den Wert von k monoton von 1 bis Q ändert, wobei P und Q ganze Zahlen kleiner als N darstellen.

**20.** Vorrichtung nach Anspruch 19, wobei die Steuereinrichtung aufweist: einen Zähler (220) mit P Zuständen in der Abfolge von 1 bis P sowie einen Koppler (224.1 bis 224.4), um Steuersignale, die denjenigen der P-Zustände, in dem sich der Zähler befindet, anzeigen, während der ersten Zeitspanne vom Zähler der ersten Gruppe von P Elementen zuzuführen und Steuersignale, die denjenigen der Q Zustände, in dem sich der Zähler befindet, anzeigen, während der zweiten Zeitspanne vom Zähler der zweiten Gruppe von Q Elementen zuzuführen, wobei Q größer als P ist.

**21.** Vorrichtung nach einem der Ansprüche 9 bis 20, wobei das Steuersignal Frequenzkorrekturen (Ausgang von 28) darstellt, die auf die periodische Wellenform angewendet werden sollen, und eine Steuerung (32, 36, 40) auf den Wert des Frequenzkorrektursignals anspricht, um die um die diskreten Zeitverzögerungen verzögerte periodische Wellenform mit dem ersten Ausgangsanschluß (46) so zu verbinden, daß dann, wenn der Wert der Frequenzkorrektur nicht 0 ist, entsprechende Änderungen in den diskreten Zeitverzögerungen der periodischen Wellenform am ersten Ausgangsanschluß auftreten, und dann, wenn der Wert der Frequenzkorrektur 0 ist, sich die Phase der verzögerten periodischen Wellenform am ersten Ausgangsanschluß nicht ändert und mit allen diskreten Zeitverzögerungen versehen ist, wobei das Frequenzkorrektursignal sehr klein ist, um die Änderung der Phase der verzögerten periodischen Wellenform am ersten Ausgangsanschluß bezüglich der an die Verzögerungsschaltung angelegten periodischen Wellenform zu ändern, nachdem viele Zyklen der periodischen Wellenform aufgetreten sind.

**22.** Vorrichtung nach einem der Ansprüche 9 bis 21, wobei die Schaltung beim Schalten in Antwort auf das Phasenänderungs-Steuersignal dazu neigt, einen Störimpuls an einem anderen Ausgangsanschluß (Ausgang von 50) zu entwickeln und eine Schaltung (48) mit dem anderen Ausgangsanschluß verbunden ist, um ein Auftreten der Störimpulse an dem anderen Ausgangsanschluß zu verhindern.

**23.** Vorrichtung nach einem der Ansprüche 9 bis 22, wobei das Steuersignal durch Erfassen einer Vorlauf-/Rücklauf-Änderung in der Phasenbeziehung der gewählten Replikation und der periodischen Wellenforn auf seinen vorbestimmten Wert gesetzt wird.

## Revendications

**1.** Méthode de décalage de la phase d'une première forme d'onde périodique (42) en une valeur choisie parmi au moins plusieurs valeurs discrètes différentes (sortie de 36), comprenant l'imposition d'un retard (44.1, 44.2, ..., 44.N) sur la forme d'onde périodique (42) pendant un temps qui est déterminé par la valeur discrète choisie, pour en déduire une autre forme d'onde périodique (46) qui est déphasée par rapport à la première forme d'onde périodique de façon que, quand la valeur discrète choisie change, le retard imposé change, caractérisée en ce que la valeur discrète choisie est rétablie (entrée remise de 36) à une valeur initiale sensible à la première forme d'onde périodique (42) quand elle est déphasée du retard imposé par un multiple entier d'à peu près un cycle de la première forme d'onde périodique (42).

**2.** Méthode suivant la revendication 1, dans laquelle ladite valeur initiale est égale à zéro.

**3.** Méthode suivant l'une quelconque des revendications précédentes, dans laquelle la valeur discrète choisie est obtenue en

> convertissant (36) un valeur représentant un retard de phase désiré (sortie de 32) de la forme d'onde périodique (42) en un signal (sortie de 36) ayant au moins plusieurs valeurs discrètes qui changent en fonction du temps, et

incrémentant (sortie de 28) la valeur discrète du signal à une certaine vitesse pour chaque unité de changement de retard de phase désiré dans un cycle de la forme d'onde périodique (42),

le retard imposé étant établi en établissant au moins plusieurs temps retard discrets (44) pour la forme d'onde périodique (42),

sélectionnant (40) un au moins parmi plusieurs temps de retard discrets de la forme d'onde périodique (42) en réponse à la valeur discrète du signal de façon qu'il y ait une correspondance entre les temps de retard discrets, auxquels la forme d'onde périodique (42) est soumise, et les valeurs de changement du signal discret,

retardant (44) la forme d'onde périodique (42) d'un temps de retard discret choisi pour en déduire une forme d'onde périodique (46) soumise à un retard, et

réalisant le rétablissement en remettant (36) la valeur discrète du signal à une valeur prédéterminée en réponse à la phase de la forme d'onde périodique soumise à un retard changeant approximativement d'un multiple entier de 360° de la phase de la forme d'onde périodique (42).

4. Méthode suivant l'une quelconque des revendications précédentes, dans laquelle la forme d'onde périodique (42) est une onde d'horloge ayant une fréquence fixe prédéterminée, la forme d'onde périodique déphasée étant une onde de sortie (sortie de 50),

en déduisant (16, 18, 22, 28) un signal numérique de commande ayant une valeur qui varie en réponse à la phase relative d'un signal d'entrée de fréquence constante (12, 14) et de l'onde de sortie (46),

en soumettant l'onde d'horloge à un retard discret parmi au moins plusieurs retards discrets (44) de façon qu'on en déduise au moins plusieurs ondes ayant des positions différentes dans le temps qui sont les répliques de l'onde d'horloge,

le retard étant imposé en choisissant (40) une des ondes ayant différentes positions dans le temps en réponse aux valeurs du signal numérique de commande (sortie de 36) pour ai déduire l'onde de sortie, et

le rétablissement (sortie de 56) causant le rétablissement de la valeur du signal numérique de commande à une valeur initiale prédéterminée à cet effet chaque fois que l'onde de sortie (sortie de 50) change de phase par rapport à l'onde d'horloge (42) d'à peu près 360° à cause du changement avance/retard dans la relation de phase de l'onde de sortie et de l'onde d'horloge.

5. Méthode suivant la revendication 4, dans laquelle l'onde de sortie et l'onde d'entrée sont telles que la valeur du signal numérique de commande (sortie de 36) change d'une manière monotone entre les rétablissements.

6. Méthode suivant l'une quelconque des revendications précédentes, dans laquelle le retard imposé est fourni en appliquant la forme d'onde périodique (208) à au moins plusieurs unités de retard (200) qui sont montées en cascade (200) et qui ont des temps de retard discrets, les valeurs discrètes changeant le nombre des unités de retard montées en cascade qui sont reliées à la forme d'onde périodique de façon que, quand la valeur du signal (sortie de 206) change, les unités de retard en cascade soient connectées à la forme d'onde périodique (208) et déconnectées (par 202 et 204) de celle-ci.

7. Méthode suivant l'une quelconque des revendications précédentes, dans laquelle la forme d'onde périodique est une horloge et dans laquelle la méthode réalise un verrouillage de phase entre une entrée à fréquence constante (12, 14) et l'horloge (42) qui a une fréquence légèrement différente de la fréquence constante, comprenant encore un échantillonnage (16, 18) de l'amplitude de l'entrée à une fréquence d'échantillonnage (sortie de 50) résultant de l'horloge déphasée, répondant à l'amplitude échantillonnée (sortie de 16, 18) pour en déduire une première représentation (sortie de 28) ayant une valeur égale à une erreur de fréquence entre la fréquence d'échantillonnage et l'entrée à fréquence constante, une intégration (32) de la première représentation pour en déduire une seconde représentation ayant une valeur proportionnelle au déphasage à imposer à l'horloge, le déphasage imposé (par 40, 44) décalant la fréquence de l'horloge (42), des valeurs voisines de déphasage parmi lesdites valeurs de déphasage étant approximativement espacées les unes des autres, le retard imposé à l'horloge (par 40, 44) étant d'un temps directement proportionnel à l'une choisie des valeurs discrètes pour en déduire l'horloge décalée en fréquence (sortie de 50).

8. Méthode suivant la revendication 7, dans laquelle le retard est imposé en déduisant (44) au moins plusieurs répliques de l'horloge de façon que les répliques voisines k (sorties de 44.1 et 44.2) soient retardées l'une de l'autre d'à peu près la même quantité, et en choisissant (par 40) la réplique qui est déphasée de l'horloge par un quantité déterminée par la valeur de la seconde représentation (sortie de 32).

**9.** Appareil destiné à décaler la phase d'une forme d'onde périodique (42) en réponse à un signal de commande (sortie de 36) représentant un changement de phase à appliquer à la forme d'onde périodique, comprenant un circuit (44) répondant à la forme d'onde périodique (42) pour en déduire au moins plusieurs répliques de la forme d'onde périodique (sorties de 44.1, ... . 44.(N-1)), les répliques ayant différents retards de temps les unes par rapport aux autres, un moyen (40) répondant au signal représentant le changement de phase (sortie de 36) pour relier l'une choisie parmi les répliques à une première borne de sortie (46) en fonction de la valeur du signal de commande, caractérisé par un moyen (56) pour redonner au signal de commande (sortie de 36) la valeur prédéterminée quand la réplique à la borne de sortie (46) est décalée d'un multiple entier d'à peu prés un cycle de la forme d'onde périodique (42).

**10.** Appareil suivant la revendication 9, dans lequel le signal représentant le changement de phase est un signal de correction de phase (34) déduit en réponse à un signal représentant une erreur de fréquence pratiquement constante (30) entre la réplique à la borne de sortie et une fréquence de référence (12), la valeur prédéterminée du signal de commande étant placée à une valeur associée avec un retard de phase de 0° pour la forme d'onde périodique (42), quand la réplique à la borne de sortie a une phase qui diffère d'à peu près Px360° de la phase de la forme d'onde périodique, après avoir été fournie à la première borne de sortie (46), où P est un entier.

**11.** Appareil suivant l'une quelconque des revendications 9 et 10, dans lequel le moyen de récupération a un retard de propagation fini (58), le moyen de récupération comportant un moyen (56) pour détecter l'apparition simultanée de mêmes transitions dans la réplique choisie à la borne de sortie (46) et une réplique de l'horloge (sortie de 58), quand elle est retardée par le retard de propagation.

**12.** Appareil suivant l'une quelconque des revendications 9 à 11, dans lequel le circuit comprend au moins plusieurs unités de retard (44) ayant des temps de retard discrets, et comprend encore un dispositif de commande (40) répondant au signal de commande (sortie de 36) pour commander des connexions des unités de retard (42) entre une borne de sortie d'une source de la forme d'onde (42) et la première borne de sortie (46), de façon que, quand la valeur du signal de commande change, il y ait des changements correspondants dans le temps de retard interposé par les unités de retard à la forme d'onde périodique entre la borne de sortie de la source de forme d'onde et la première borne de sortie, les unités de retard (44) étant montées en cascade l'une avec l'autre, le dispositif de commande (40) répondant à la valeur du signal de commande pour effectivement commander le nombre d'unités de retard montées en cascade entre la borne de sortie de la source et l'autre borne de sortie, de façon que, quand la valeur du signal de commande change, il y ait des changements correspondants dans le nombre d'unités de retard montées effectivement en cascade entre les bornes de sortie, le dispositif de commande choisissant la sortie de l'une des unités de retard et la reliant à la première borne de sortie.

**13.** Appareil suivant la revendication 12, dans lequel le dispositif de commande comprend un multiplexeur (40) ayant une première borne d'entrée (38) sensible au signal de commande pour choisir la sortie de l'une des unités de retards et la relier à l'autre borne de sortie (46), le multiplexeur ayant 1, 2, ..., N bornes d'entrée de signal (0, ..., (N-1)) en réponse respectivement à 1, 2, ..., N répliques retardées de l'onde aux bornes de sortie des unités de retard 1, 2, ..., N, le temps de retard de la réplique retardée à la borne d'entrée k dépassant le temps de retard des répliques retardées aux bornes d'entrée 1, 2, ..., (k-1), où k est respectivement l'un des entiers de 2 à N, le signal de commande, auquel le multiplexeur est sensible, étant un signal numérique codé réfléchi de M bits (sortie de 36) ayant une valeur indiquant le déphasage à introduire entre la borne de sortie de la source de forme d'onde et l'autre borne de sortie, l'autre borne de sortie étant une borne de sortie du multiplexeur, le multiplexeur comprenant (N-1) portes (70), dont chacune possède: (a) des première et seconde entrées de signal (A et B), (b) une sortie de signal, et (c) une entrée de commande (S) répondant à un bit du signal codé réfléchi (sortie de 36) pour router le signal sur l'une des deux entrées de signal (A et B) vers la sortie de signal en fonction de la valeur du bit à l'entrée de commande (S); les signaux d'entrée et les signaux de sortie des portes (70) étant reliés (a) entre eux, (b) aux bornes d'entrée du multiplexeur (40) et (c) à la borne de sortie (46) du multiplexeur, et les entrées de commande des portes étant reliées pour répondre aux M bits du signal numérique codé réfléchi, de façon que, quand la valeur du signal réfléchi change d'une valeur réfléchie représentant la valeur en base 10 de i à (i+1), le signal sur la borne d'entrée i du multiplexeur se change en signal sur la borne d'entrée (i+1) du multiplexeur, où i est choisi sélectivement parmi 0, 1, 2, ..., (N-2).

**14.** Appareil suivant l'une quelconque des revendications 9 à 11, dans lequel le décalage de phase est interposé entre une borne de sortie (212) d'une source de la forme d'onde et la première borne de sortie (sortie de 200.1), le circuit comprenant au moins plusieurs unités de retard 1, 2, ..., N (200) ayant des temps de retard discrets, un moyen de commande (202, 204, 206) sensible à la valeur du signal de commande (sortie de 220) pour commander des connexions des unités de retard entre la borne de sortie de la source de forme d'onde et l'autre borne de sortie, de façon que, quand la valeur du signal de commande change, il y ait des changements correspondants de temps de retard interposé par les unités de retard (200) sur la forme d'onde périodique entre la borne se sortie de la source de forme d'onde et la première borne de sortie, les unités de retard étant montées en cascade l'une avec l'autre, le moyen de commande (202, 204, 206) étant sensible à la valeur du signal de commande pour effectivement commander le nombre d'unités de retard à monter en cascade entre la borne de sortie de la source (212) et la première borne de sortie (sortie de 200.1), de façon que, quand la valeur du signal de commande change, il y ait des changements correspondants dans le nombre des unités effectivement montées en cascade entre l'autre borne de sortie et les bornes de sortie desdites unités de retard 1, 2, ..., N, l'unité de retard 1 (200.1) étant reliée avec sa sortie reliée à ladite première sortie sans liaison par une autre quelconque desdites N unités de retard, les liaisons de commande (fournies par 202, 204) du moyen de commande entre les bornes d'entrée et de sortie des unités de retard et entre la borne de sortie (212) de la source et la borne d'entrée de ladite unité de retard 1, de façon qu'en réponse au signal de commande ayant un valeur commandant k dans lesdites unités de retard à monter en cascade entre la borne de sortie (212) de la source et la première borne de sortie, la borne d'entrée de l'unité de retard k soit reliée à la borne de sortie de la source sans liaison par une autre quelconque desdites unités de retard N, et la borne de sortie de l'unité de retard j est reliée à la borne d'entrée de l'unité de retard (j-1), où k est sélectivement tout entier entre 2 et N, et j est sélectivement chaque entier entre 2 et k.

15. Appareil suivant la revendication 14, dans lequel le moyen de commande établit une liaison (202.(k-1)) entre les unités de retard k et (k-1), avant de rompre une liaison entre une entrée de l'unité de retard (k-1) et la borne de la source de forme d'onde en réponse au nombre d'unités de retard interposées entre la borne de sortie de la source et une autre borne de sortie passant de k à (k-1).

16. Appareil suivant l'une quelconque des revendications 9 à 15, dans lequel l'appareil est inclus dans une boucle de verrouillage de phase (Fig. 1) comprenant un convertisseur analogue-numérique (16, 18) sensible à un jeu de bits (12, 14) représentant l'information, au moins une portion de l'information ayant tendance à se dégrader, la convertisseur déduisant un signal numérique de plusieurs bits représentant une amplitude de l'information en réponse à un train d'onde échantillonné (sortie de 50) déduit en réponse à une forme d'onde périodique décalée à la première borne de sortie, et des moyens (22, 28, 32) sensibles au convertisseur pour déduire des signaux représentant des erreurs de fréquence (sortie de 28) et de phase (sortie de 32) entre l'information et la forme d'onde périodique décalée à la première borne de sortie; le signal qui représente l'erreur de phase commandant le signal de commande.

17. Appareil suivant l'une quelconque des revendications 9 à 16, dans lequel la première borne de sortie, la fréquence de la forme d'onde périodique, la valeur du signal de commande et l'appareil sont tels que le nombre des unités de retard effectives entre la borne de sortie de la source et la première borne de sortie change toujours d'une manière monotone en une fonction du temps.

18. Appareil suivant l'une quelconque des revendications 9 à 17, dans lequel l'appareil fait partie d'un oscillateur à fréquence variable, l'appareil comprenant encore: une source de commande (sortie de 28) pour changer la fréquence de l'oscillateur, une valeur de signal déduite par la source de commande étant 0 pour une sortie de fréquence constante de l'oscillateur à la première borne de sortie et étant différente de 0 pour des changements de fréquence de sortie de l'oscillateur, et un moyen pour intégrer (32) la valeur déduite par la source de commande pour commander la quantité de temps de retard interposé par les unités de retard sur la forme d'onde périodique.

19. Appareil suivant la revendication 14, dans lequel le moyen de commande (205) divise les N éléments en plusieurs unités de retard groupes (chaque groupe étant associé avec l'un de 224.1 à 224.4), le moyen de commande changeant d'une manière monotone la valeur de k de 1 à P pour un premier groupe de P des N éléments pendant un premier intervalle de temps, puis changeant d'une manière monotone la valeur de k de 1 à Q pour un deuxième groupe de Q des éléments pendant un deuxième intervalle de temps, où P et Q sont des entiers inférieurs à N.

20. Appareil suivant la revendication 19, dans lequel le moyen de commande comprend un compteur (220) ayant P états qui sont séquencés de 1 à P, et un coupleur (224.1 à 224.4) pour coupler des signaux indicatifs de ceux des P états où est le compteur, à partir du compteur au premier groupe de P éléments pendant le premier intervalle de temps, et pour coupler des signaux de commande indicatifs de ceux des états Q où est le compteur au deuxième groupe des Q éléments pendant le deuxième intervalle de temps, où Q est supérieur à P.

21. Appareil suivant l'une quelconque des revendications 9 à 20, dans lequel le signal de commande représente des corrections de fréquence (sortie de 28) à appliquer à la forme d'onde périodique et un dispositif de commande (32, 36, 40) répond à la valeur du signal de correction de fréquence pour coupler la forme d'onde périodique retardée par les retards de temps discrets à la première borne de sortie (46) de façon que, quand la valeur de la correction de fréquence n'est pas nulle, il y ait des changements correspondants dans les retards de temps discrets de la forme d'onde périodique à la première borne de sortie et que, quand la valeur de la correction de fréquence est nulle, la phase de la forme d'onde périodique retardée à la première borne de sortie ne change pas et est susceptible d'avoir tous les retards de temps discrets, le signal de correction de fréquence étant très petit pour ainsi changer la phase de la forme d'onde périodique à la première borne de sortie par rapport à la forme d'onde périodique appliquée au circuit de retard après que soient survenus de nombreux cycles de la forme d'onde périodique.

22. Appareil suivant l'une quelconque des revendications 9 à 21, dans lequel le circuit, quand il est commuté en réponse au signal de commande de changement de phase, a une tendance à dériver d'un bug à une autre borne de sortie (sortie de 50), et un circuit (48) couplé à l'autre borne de sortie pour empêcher le couplage des bugs à l'autre borne de sortie.

23. Appareil suivant l'une quelconque des revendications 9 à 22, dans lequel le signal de commande est donc mis à la valeur prédéterminée en détectant un changement avance/retard dans la relation de phase des répliques choisies et la forme d'onde périodique.

Fig.1

Fig. 2

EP 0 627 137 B1

Fig. 3

Fig. 4

EP 0 627 137 B1

Fig. 6

Fig. 5